# EUROPEAN PATENT SPECIFICATION

(11) **EP 1 772 441 B1**
(45) Date of publication and mention of the grant of the patent: **30.11.2011**
(21) Application number: 06121639.6
(22) Date of filing: 02.10.2006
(51) Int. Cl.: C04B 35/486

(54) **Ceramic material and coatings for high temperature service**
Keramisches Material und Hochtemperaturbeschichtungen
Matériau céramique et revêtements pour des applications à haute température

(30) Priority: 07.10.2005 US 724268 P
(43) Date of publication of application: 11.04.2007
(73) Proprietor: Sulzer Metco (US) Inc., Westbury, NY 11590 (US)
(72) Inventor: Doesburg, Jacobus C. c/o Sulzer Metco (US) Inc., Westbury, New York 11590 (US); Xie, Liangde c/o Sulzer Metco (US) Inc., Westbury, New York 11590 (US); Schmid Richard K.,Dr., 8500 Gerlikon (CH); Gold Matthew c/o Sulzer Metco (US) Inc., Westbury, New York 11590 (US); Dorfman Mitchell, c/o Sulzer Metco (US) Inc., Westbury, New York 11590 (US)
(74) Representative: Sulzer Management AG

(56) References cited:
- US-A- 4 520 114
- US-A1- 2003 138 658
- G.ANTHOU ET AL.: "Processing of Yttria Partially Stabilized Zirconia Thermal Barrier Coatings Implementing a High-Power Laser Diode", JOURNAL OF THERMAL SPRAY TECHNOLOGY, vol. 13, no. 3 , pages 381-389,

## Description

### CROSS REFERENCE TO RELATED APPLICATIONS

This application claims priority under 35 U.S.C. § 119(e) from U.S. Provisional Patent Application Nos. 60/724,268, filed on October 7, 2005, which is incorporated herein in its entirety by reference.

### BACKGROUND OF THE INVENTION

### Field of the Invention

The invention relates to ceramic materials for thermal barriers coating systems in high temperature cycling applications, and more particularly to ultra-pure zirconia- and/or hafnia-based materials for use in thermal barrier coating applications.

### Description of the Related Art

Superior high-temperature properties are required to improve the performance of heat resistant and corrosion resistant members. These members include, for example gas turbine blades, combustor cans, ducting and nozzle guide vanes in combustion turbines and combined cycle power plants. Turbine blades are driven by hot gasses, and the efficiency of the gas turbine increases with the rise in operational temperature. The demand for continued improvement in efficiency has driven the system designers to specify increasingly higher turbine operating temperatures. Thus, there is a continuing need for materials that can achieve higher operational temperatures.

Thermal barrier coatings are used to insulate components, such as those in a gas turbine, operating at elevated temperatures. Thermal barriers allow increased operating temperature of gas turbines by protecting the coated part (or substrate) from direct exposure to the operating environment. An important consideration in the design of a thermal barrier is that the coating be a ceramic material having a crystalline structure containing beneficial cracks and voids, imparting strain tolerance. If there were no cracks in the coating, the thermal barrier would not function, because the differences in thermal expansion between the metal substrate system and the coating will cause interfacial stresses upon thermal cycling that are greater than the bond strength between them. By the creation of a crack network into the coating, a stress relief mechanism is introduced that allows the coating to survive numerous thermal cycles. Repeating crack networks are typically imparted into the coating on varying space scales by manipulating the thermodynamic and kinetic conditions of the manufacturing method, and different structures known to perform the coating task have been optimized likewise. In addition to this, cracks are also formed during service, so the structure formed upon coating manufacture changes with time, depending on the starting material phases in the manufactured coating and thermal conditions during service.

Another design factor determining coating lifetime is the sintering rate of the coating. When the coating is cycled above half of its absolute melting temperature, the coating begins to sinter causing volume shrinkage. As the coating shrinks, the stress difference between the coating and substrate increases. At a certain amount of shrinkage (which varies depending on the type of structure and thermal conditions during service), the stress difference exceeds the bonding strength of the coating and it becomes detached. Decreasing the sintering rate of the thermal barrier increases the amount of time before the catastrophic shrinkage is experienced, so it can become a major design consideration. For high purity zirconia alloys, the onset of sintering commences at temperatures above 1000°C.

Historically, high temperature thermal barrier coatings have been based on alloys of zirconia. Hafnia may also be employed due to its chemical similarity to zirconia, but is generally cost-prohibitive. Hafnia also is typically present in most zirconia materials in more than trace amounts due to difficulty in separating the two oxides. Zirconia and/or hafnia have the following combination of desirable properties that other known ceramic systems do not possesses for the application. First, zirconia alloys have some of the highest melting points of all ceramics, and this means theoretically some of the highest temperatures for which the onset of sintering occurs. Second, zirconia alloys have one of the lowest thermal conductivities of all ceramics. Third, zirconia has one of the highest coefficients of thermal expansion of all ceramics, so it is most compatible with transition metal alloys during thermal cycling.

Zirconia alone cannot fulfill the coating requirements because it undergoes a phase transformation from tetragonal to monoclinic during thermal cycling. This transformation is presumed to cause a detrimental volume change resulting in large strain differences between the coating and the substrate. When the resulting stresses exceed the bond strength of the coating to the substrate, the coating will detach. For this reason a phase stabilizer is added to the zirconia and/or hafnia, such as yttria, which suppresses the tetragonal to monoclinic phase transformation.

Thermal spray abradable coatings are commonly used in gas turbine applications. Abradable coatings are designed to preferentially abrade when contact is made with a mating part. These coatings have low structural integrity so they are readily abraded when they come into contact with a moving surface with higher structural integrity (such as the blade of a turbine). The coatings are designed so as not to damage the mating surface. In many applications abradable coatings are subject to the same thermal cycling conditions as the thermal barriers described above. Thus, there is a continuing need for materials suitable for abradable coatings that can achieve higher operational temperatures.

A major disadvantage brought about by using typical zirconia coating systems is that zirconia is transparent to radiation in the infrared range. As thermal barriers are sought for higher temperatures, zirconia becomes limited in its effectiveness. The main mechanism of heat transfer for zirconia changes from conduction to radiation at temperatures approaching 1500°C. Since zirconia is nearly transparent to the heat radiation (in the form of photons) above those temperatures, its main function as a heat barrier becomes reduced. Thus, there remains a need in the art for a zirconia-based thermal barrier material that remains optimized at temperatures from 1200°C to above 1500°C.

Some previous efforts to improve coating life have focused on the coating material and microstructure upon entry into service. However, the heat cycle of in service parts also causes cracks throughout the service life of the part. Thus, the microstructure formed upon coating manufacture changes with time, depending on the starting material phases in the manufactured coating and thermal conditions during service. Because a consistent optimal crack network is not typically maintainable throughout the service life of the part, coating lifetime is ultimately determined by the material selection and its manufacturing process. There remains a need in the art for a coating material, coating material manufacturing method, and coating manufacturing method that address the changes in the coating microstructure during its service lifetime.

Today, TBCs are widely used in gas turbines. In order to function as a thermal barrier, TBC materials must meet the following requirements: (1) low thermal conductivity; (2) high coefficient of thermal expansion; (3) high melting point; (4) high thermal shock resistance; and (5) be resistant to erosion, (6) compatibility with bond coat. When all these requirements are considered, 6~9 weight percent yttria stabilized zirconia (7YSZ) is the conventional material of choice. The thermal conductivity of 7YSZ TBCs deposited using air plasma spray can be as low as 0.8 W/(Km). However, the thermal conductivity can go up to 1.5~2.0 W/(Km) after high temperature exposure as a result of sintering, which significantly deteriorate the thermal insulation capability of TBCs. In addition, the elimination of microcracks and fine void due to sintering leads to the increase of coating stiffness, which has an adverse effect on coating durability. Accordingly, there is a quest to find new materials and to optimize coating structures so as to produce a TBC that has prolonged durability and can provide excellent thermal insulation over extended period of service time.

Large gas turbine engines are typically of the axial type, and include a compressor section, a combustor section, and a turbine section, with the compressor section normally preceded by a fan section. Each of the fan, compressor, and turbine sections comprises a plurality of disks mounted on a shaft, with a plurality of airfoil shaped blades projecting radially therefrom. A hollow case surrounds the various engine sections. Located between the disks and projecting inward from the case assembly which surrounds the disks are a plurality of stationary vanes. During operation of the fan, compressor, and turbine sections, axially flowing gases alternately contact moving blades and the stationary vanes. In the fan and compressor sections, air is compressed and the compressed air is combined with fuel and burned in the combustion section to provide high pressure, high temperature gases that flow through the turbine section, where energy is extracted by causing the bladed turbine disks to rotate. A portion of this energy is used to operate the compressor section and the fan section.

Engine efficiency depends to a significant extent upon minimizing leakage by control of the gas flow in such a manner as to maximize interaction between the gas stream and the moving and stationary airfoils. A major source of inefficiency is leakage of gas around the tips of the compressor blades, between the blade tips and the engine case. Accordingly, means to improve efficiency by reduction of leakage are increasingly important. Although a close tolerance fit may be obtained by fabricating the mating parts to a very close tolerance range, this fabrication process is extremely costly and time consuming. Further, when the mated assembly is exposed to a high temperature environment and high stress, as when in use, the coefficients of expansion of the mating parts may differ, thus causing the clearance space to either increase or decrease. The latter condition would result in a frictional contact between blades and housing, causing elevation of temperatures and possible damage to one or both members. On the other hand, increased clearance space would permit gas to escape between the compressor blade and housing, thus decreasing efficiency.

One means to increase efficiency is to apply a coating of suitable material to the interior surface of the compressor and/or turbine housing, to reduce leakage between the blade tips and the housing. Various coating techniques have been employed to coat the inside diameter of the compressor and/or turbine housing with an abradable coating that can be worn away by the frictional contact of the blade, to provide a close fitting channel in which the blade tip may travel. Thus, when subjecting the coated assembly to a high temperature and stress environment, the blade and the case may expand or contract without resulting in significant gas leakage between the blade tip and the housing. This abradable coating technique has been employed to not only increase the efficiency of the compressor/turbine, but to also provide a relatively speedy and inexpensive method for restoring excessively worn turbine engine parts to service.

Increased firing temperatures is another approach to improved engine efficiency. However, even nickel and cobalt superalloys are not capable of surviving long term operation at the firing temperatures of modem gas turbine engines that may exceed 1,400°C in oxidizing environments. In order to provide additional protection to the metal components in the hottest areas of a gas turbine engine, it is known to coat the metal substrate with a layer of ceramic material to thermally insulate and chemically isolate the substrate from the hot combustion gasses. A widely used material for this application is yttria stabilized zirconia (YSZ), with 6-9 weight percent yttria (Y₂O₃) being a common composition.

Abradable thermal barrier coatings require a highly porous coating network of, typically, between 20-35 percent porosity, which cannot be achieved by conventional flame spray techniques. Porosity is needed in order for the turbine blades to cut grooves in the abradable coating. Previous testing of ceramic materials has shown that high porosity levels, in excess of about 35 volume percent, produce coatings prone to erosion damage. Porosity levels of less than about 20 volume percent are unsatisfactory because they cause excess blade tip wear. The material from which the coating is formed must abrade relatively easily without wearing down the blade tips. This requires a careful balance of materials in the coatings. In this environment, an abradable coating must also exhibit good resistance against particle erosion and other degradation at elevated temperatures. As known by those skilled in the art, however, these desirable characteristics have been difficult to obtain. The porosity levels achieved by conventional techniques for ceramic coatings using conventional powders normally range between 5 and 20 percent, and the porosity level, it has been found, is a direct function of the powder size and spraying parameters, e.g., spray rate, spray distance and power levels of the spray gun.

Past turbine sealing structures have taken a variety of forms. Some of the currently favored approaches include complex plasma sprayed structures that vary in composition from metal at one surface to ceramic at an outer surface with variations in composition, stress and porosity in between. These structures usually have a thickness on the order of 4 mm and are costly because of the need to carefully control the substrate temperature and plasma spray conditions, during the deposition of many layers, to achieve the correct abradable and durable structure. Such thick seal structures will spall and fail if the deposition parameters are not followed closely. Likewise in service these seals with their built-in varying stresses are subject to foreign object damage. When failure of thick seals does occur excess leakage results through the resulting wide gap.

With continuing efforts to improve gas turbine efficiency through use of better seals and use of higher temperatures, there remains a need in the art for coating materials and coating application methods that provides improved high-temperature properties and wear characteristics for abradable thermal barrier coatings.

### SUMMARY

Accordingly, the invention is directed to a ceramic material for use in thermal barriers for high temperature cycling applications and high temperature abradable coatings. The material is an alloy formed predominantly from ultra-pure stabilized zirconia (ZrO₂) and/or hafnia (HfO₂) alloys that have uncharacteristically high sintering resistance to achieve a high service lifetime. The invention provides a desired coating material so that the changes in the coating microstructure over the in-service lifetime are retarded.

The limits for impurities discovered to decrease sintering rate and therefore increase service lifetime compared with current impurity concentrations when used as a coating and partially stabilized with a rare earth oxide, for example, yttria (Y₂O₃) and/or ytterbia (Yb₂O₅), are disclosed herein. Oxide impurities are defined as materials which, when combined with each other or with zirconia and/or hafnia, form phases with melting points much lower than that of pure zirconia and/or hafnia, such as but not limited to soda (Na₂O), silica (SiO₂) and alumina (Al₂O₃).

In one aspect, the invention provides a blended ceramic and placeholder material for use in high-temperature thermal barriers or abradable seal coatings. The said material has about 4 to 20 weight percent of a stabilizer of one or more rare earth oxides; and a balance of at least one of zirconia (ZrO₂), hafnia (HfO₂) and combinations thereof, wherein the zirconia (ZrO₂) and/or hafnia (HfO₂) is partially stabilized by the stabilizer, and wherein the total amount of impurities is less than or equal to 0.15 weight percent.

Aspects of the invention also provide high purity coating structures suitable for high temperature cycling applications and for application onto a substrate. In one structure, the coating included a ceramic matrix, porosity and micro cracks. In another structure, the coating included a ceramic matrix, porosity, macro cracks and micro cracks. In another structure, the coating comprises ceramic columns and gaps between the columns. In another structure, the coating comprises ceramic columns, gaps between the columns and nodules distributing randomly in the gaps and columns.

In one aspect, the invention provides a high-purity coating structure suitable for high temperature cycling applications formed by the process of providing in a form suitable for use in thermal spraying applications a material of about 4 to 20 weight percent of a stabilizer of one or more rare earth oxides, and a balance of at least one of zirconia (ZrO₂), hafnia (HfO₂) and combinations thereof, wherein the zirconia (ZrO₂) and/or hafnia (HfO₂) is partially stabilized by the stabilizer, and wherein the total amount of impurities is less than or equal to 0.15 weight percent. The material is then sprayed onto a metal substrate (or optional bond coat) using a thermal spray process at pressures between 1 Pa and 1 MPa, so as to form a stream of molten and/or semi-molten droplets that build up a coating of frozen lamellar splats subsequent to impact with the substrate.

Another aspect of the invention provides a high-purity coating structure that is suitable for high temperature cycling applications, said coating structure formed by the process of providing a material consisting essentially of about 4 to 20 weight percent of a stabilizer of one or more rare earth oxides, and a balance of at least one of zirconia (ZrO₂), hafnia (HfO₂) and combinations thereof, wherein the zirconia (ZrO₂) and/or hafnia (HfO₂) is partially stabilized by the stabilizer, and wherein the total amount of impurities is less than or equal to 0.15 weight percent. The material is then sprayed onto a metal substrate (or optional bond coat) using a vapor deposition process at pressures between 1 mPa and 1 kPa, so as to form a coating with ceramic columns and gaps between the columns.

In yet another aspect of the invention, an essentially-columnar high-purity coating structure that is suitable for high temperature cycling applications, said coating structure formed by the process of providing a material consisting essentially of about 4 to 20 weight percent of a stabilizer of one or more rare earth oxides, and a balance of at least one of zirconia (ZrO₂), hafnia (HfO₂) and combinations thereof, wherein the zirconia (ZrO₂) and/or hafnia (HfO₂) is partially stabilized by the stabilizer, and wherein the total amount of impurities is less than or equal to 0.15 weight percent. The material is then sprayed onto a metal substrate (or optional bond coat) using a low pressure plasma spray process at pressures between 1 Pa and 10 kPa, so as to form a coating having ceramic columns, gaps between the columns, and frozen droplets distributed randomly in the gaps and columns.

In a further aspect of the invention, a high-purity coating is provided. The coating includes about 4 to 20 weight percent of a stabilizer of one or more rare earth oxides and a balance of at least one of zirconia (ZrO₂), hafnia (HfO₂) and combinations thereof, wherein the zirconia (ZrO₂) and/or hafnia (HfO₂) is partially stabilized by the stabilizer, and wherein the total amount of impurities in the coating is less than or equal to 0.15 weight percent.

One other aspect of the invention provides a method for producing a high-purity coating structure suitable for high temperature cycling applications. The method includes providing a material consisting essentially of about 4 to 20 weight percent of a stabilizer of one or more rare earth oxides, and a balance of at least one of zirconia (ZrO₂), hafnia (HfO₂) and combinations thereof, wherein the zirconia (ZrO₂) and/or hafnia (HfO₂) is partially stabilized by the stabilizer, and wherein the total amount of impurities is less than or equal to 0.15 weight percent. The method also includes spraying said material onto a metal substrate using a thermal spray process.

In a further aspect of the invention is directed to a material and method for obtaining a ceramic abradable system for high temperature applications. High purity partially stabilized zirconia (ZrO₂) and/or hafnia (HfO₂) base material has a higher sintering resistance compared to conventional 6-9 weight percent ytrria (Y₂O₃) stabilized zirconia systems. The benefits of these systems are higher service lifetime and low thermal conductivity to achieve high operating temperatures. System includes a superalloy substrate, oxidation resistant bond coat and a thick ceramic abradable top coat. Total coating thickness may be in the range of about 0.5-5.0 mm. In some applications an intermediate layer of high purity partially stabilized zirconia or a partially stabilized YSZ/MCrAlY cermet is applied over the oxidation resistant bond coat. In other applications an abradable system is applied on top of a grid. Additional benefits should be reduced blade wear at high operating conditions. The invention provides desired coating structures so that the changes in the coating microstructure over the in-service lifetime are either limited or beneficial. Typical porosity levels may be between about 10-60 volume percent and are achieved using a fugitive material of polymer, carbon or hollow ceramic particles. The coating may be applied using thermal spray methods.

In another aspect of the invention a blended ceramic material of one or more ceramic materials is provided. Each of the ceramic materials is for use in high-temperature thermal barriers or abradable seal coatings and is supplied in the form of one of a powder or a slurry of partially stabilized powder. Each of the ceramic materials has about 4 to 20 weight percent of a stabilizer of one or more rare earth oxides and a balance of at least one of zirconia (ZrO₂), hafnia (HfO₂) and combinations thereof, wherein the zirconia (ZrO₂) and/or hafnia (HfO₂) is partially stabilized by the stabilizer, and wherein the total amount of impurities of the blended ceramic material is less than or equal to 0.15 weight percent. Additional ceramic materials or placeholder materials may also be included in the blended material. One other aspect of the invention is to provide a blend of ceramic materials for use in high-temperature thermal barriers or abradable seal coatings that have reduced sintering rates in addition to photon blocking or scattering characteristics.

Additional aspects and advantages of the invention will be set forth in the description which follows, and in part will be obvious from the description, or may be learned by practice of the invention. The aspects and advantages of the invention may be realized and obtained by means of the instrumentalities and combinations particularly pointed out hereinafter.

### BRIEF DESCRIPTION OF THE DRAWINGS

The accompanying drawings are included to provide further understanding of the invention and are incorporated in and constitute a part of this specification. The accompanying drawings illustrate embodiments of the invention and together with the description serve to explain the principles of the invention. In the figures:
FIG. 1 illustrates a perspective view of a turbine blade coated with a thermal barrier of ceramic material;
FIG. 2A provides a phase diagram for ZrO₂;
FIG. 2B provides a standard phase diagram for stabilized ZrO₂ showing the general alloying trends for various stabilizers [Ceramic Phase Diagram, Volume 4, Fig 05241];
FIG. 2C provides a phase diagram for ZrO₂ with stabilizer;
FIG. 2D provides a chart of composition vs. thermal cycles to failure for yttria stabilized zirconia;
FIG. 3 provides a photomicrograph of a typical thermal barrier containing porosity and micro cracks
FIG. 4 provides a graph of in-plane sintering resistance of ceramic at 1400°C;
FIG. 5 provides a diagram showing a lamellar thermal barrier coating structure containing porosity and microcracks
FIG. 6 provides a diagram showing a thermal barrier coating containing porosity, micro cracks and macro cracks
FIG. 7 provides a diagram showing a thermal barrier coating deposited from the vapor phase.
FIG. 8 provides a diagram showing the Thomton model for predicting structure of a coating formed from the gas phase; and
FIG. 9 provides a diagram showing a thermal barrier coating deposited from both vapor and liquid phase.
FIG. 10A provides a diagram showing a lamellar thermal barrier coating structure formed from a blend of components containing porosity and micro cracks;
FIG. 10B provides a diagram showing a dense solid thermal barrier coating structure formed from a blend of components, containing macro cracks, porosity and micro cracks;
FIG. 11 provides a diagram showing a columnar thermal barrier coating structure formed from a blend of components;
FIG. 12 provides a diagram showing a thermal barrier coating structure formed from a blend of components and a placeholder;
FIG. 13 provides a diagram showing a thermal barrier coating containing a compositional gradient;
FIG. 14 provides a diagram showing a thermal barrier coating containing layers each of a different composition;
FIG. 15 provides a diagram showing a thermal barrier coating containing a series of layers each of a different composition;
FIG. 16 illustrates a typical ceramic abradable system; and
FIG. 17 provides a diagram showing a model for ceramic abradables.

### DETAILED DESCRIPTION OF THE INVENTION

Reference will now be made in detail to the preferred embodiments of the invention, examples of which are illustrated in the accompanying drawings.

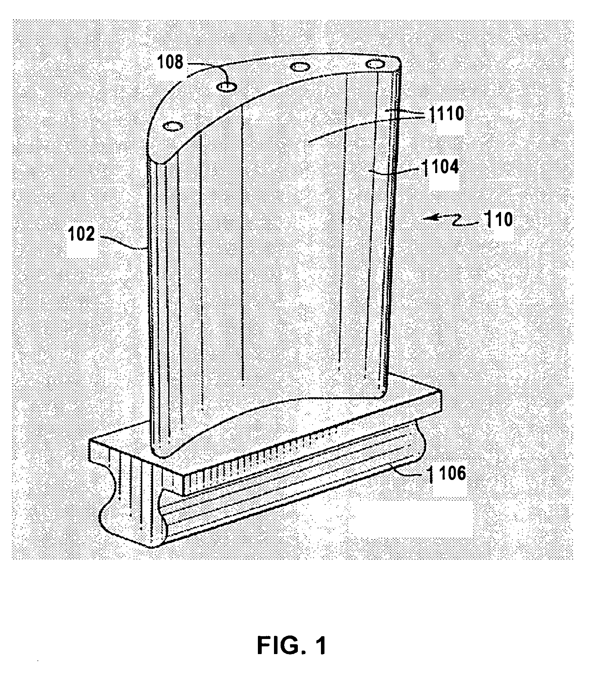

In an exemplary use of a material of the invention, FIG. 1 shows one component of a turbine. Turbine blade (or substrate) 10 has a leading edge 102 and an airfoil section 104, against which hot combustion gases are directed during operation of the turbine, and which undergoes severe thermal stresses, oxidation and corrosion. A root end 106 of the blade anchors the blade 10. Venting passages 108 may be included through the blade 100 to allow cooling air to transfer heat from the blade 10. The blade 10 can be made from a high temperature resistant material. The surface of the blade 10 is coated with a thermal barrier coating 110 made of ultra-pure zirconia (ZrO₂) and/or hafnia (HfO₂) alloys in accordance with embodiments of the invention. The thermal barrier coating 110 may be applied on, for example, a MCrAlY bonding layer with an alumina scale (not shown) applied between the blade surface and the coating 110. The coating 110 may be applied onto the bond coating surface through a variety of methods known in the art including thermal spray techniques such as powder flame spray and plasma spray and vapor deposition methods such as electron beam physical vapor deposition (EBPVD), high speed physical vapor deposition and low pressure plasma spraying (LPPS).

When applied, the coating 110 contains a crack network that allows it to survive the stress of numerous thermal cycles. As described in the above background section, the crack network is altered to a less desirable state by sintering and temperature cycling during service. Thus the structure formed upon coating manufacture changes with time, the rate depending on the starting material phases. Decreasing the sintering rate increases the amount of time before the closing of microcracks and creation of massive cracks, increasing coating lifetime.

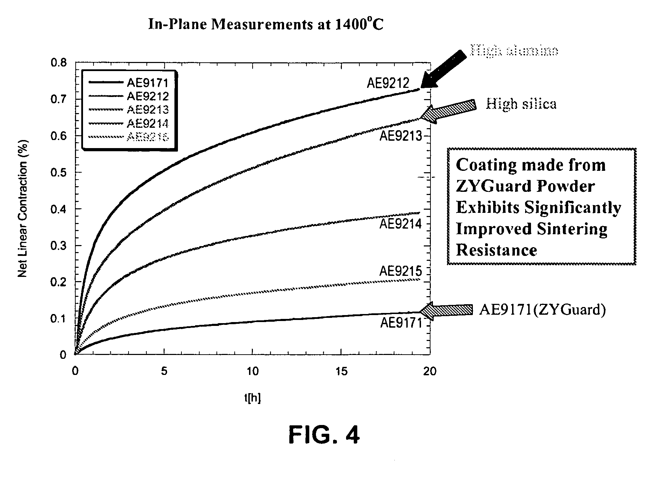

A dominant factor affecting sintering is the presence of specific impurity phases within the structure made up of oxides which when combined with each other or the zirconia alloy result in melting points hundreds of degrees lower than that of the zirconia alloy itself. These impurity oxides increase the sintering rate. FIG. 4 shows the effect of impurity on the sintering rate.

The material of the invention is a high purity zirconia and/or hafnia based material. For purposes of the present invention, oxide impurities can be defined as oxides other than the intended ingredients, such as-but not limited to-soda (Na₂O), silica (SiO₂) and alumina (Al₂O₃). In accordance with the invention, the maximum limits for known impurities in order to decrease sintering rate and therefore increase service lifetime when used as a coating and stabilized with, for example, yttria, are about:
soda (Na₂O) - 0.1 weight percent
silica (SiO₂) - 0.05 weight percent
alumina (Al₂O₃) - 0.01 1 weight percent
titania (TiO₂) - 0.05 weight percent
hematite (Fe₂O₃) - 0.05 weight percent
calcia (CaO) - 0.05 weight percent, and
magnesia (MgO) - 0.05 weight percent.
In another embodiment, the limits for known impurities are about:
Na₂O - 0.01 weight percent
SiO₂ - 0.01 1 weight percent
Al₂O₃ - 0.01 weight percent
TiO₂ - 0.01 weight percent
Fe₂O₃ - 0.01 weight percent
CaO - 0.025 weight percent, and
MgO - 0.025 weight percent.
The impurity limits in the embodiments above are not indicative that any or all of the impurities listed will be included in the material in any amount. The embodiment of the invention may include zero weight percent of one or more of the above-listed impurities.

In one particular embodiment, when used as a coating and stabilized with yttria (Y₂O₃), the maximum limits for known impurities are:
Na₂O - 0.002 weight percent
SiO₂ - 0.005 weight percent
Al₂O₃ - 0.015 weight percent
TiO₂ - 0.002 weight percent
Fe₂O₃ - 0.04 weight percent
CaO - 0.02 weight percent
MgO - 0.002 weight percent
Cr₂O₃ - 0.001 weight percent.

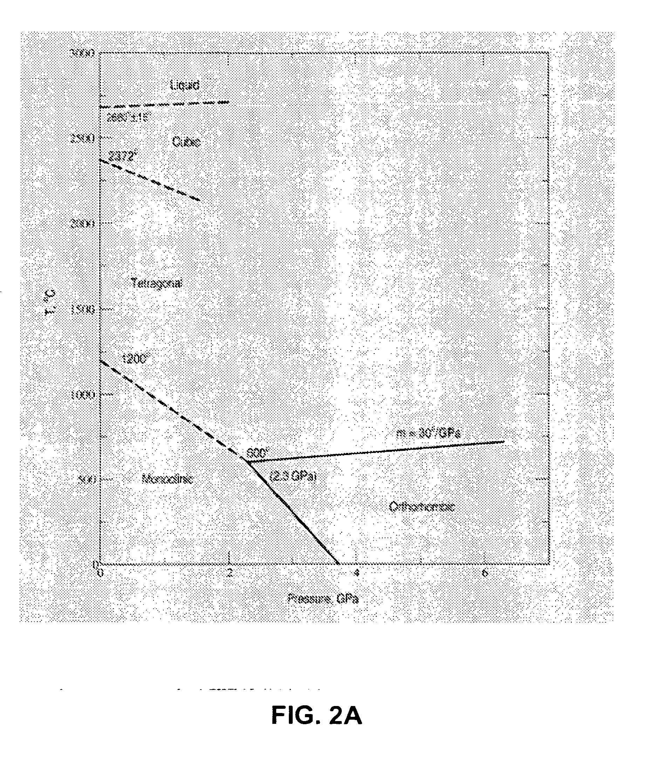

FIG. 2A provides a phase diagram for pure zirconia. (The diagram can be found, for example, in Ceramic Phase Diagram vol. 3, figure 04259.) As shown in FIG. 2A, pure zirconia exists in three crystal phases at different temperatures. At very high temperatures (>2370°C) the material has a cubic structure. At intermediate temperatures (1200 to 2372°C) it has a tetragonal structure. At low temperatures (below 1200°C) the material transforms to the monoclinic structure. The transformation from tetragonal to monoclinic is accompanied by a 3 to 5 percent volume increase that causes extensive stress in the material. Thus, pure zirconia cannot fulfill the coating requirements for high-temperature cyclic applications. The resulting strain difference between the coating and substrate caused by the phase transformation results in a stress that is greater than the bond strength between them, so the coating will detach.

In accordance with embodiments of the invention, in order to overcome the volume change caused by the undesired phase transformation described above, one or more elements are added to the zirconia to modify the amount of phase transformation that occurs. The stabilizing elements, which are suitable for changing the amount and rate of phase transformation that occurs in the oxide coating, may include the following: scandium, yttrium and the rare earths, particularly the lanthanides, since they have solubility in zirconia. Scandium is not typically used due to its rarity and resulting prohibitive cost. Use of rare earths metals from the actinide group such as uranium and thorium may be limited due to their radioactivity. Thus, yttrium is a preferred stabilizing element.

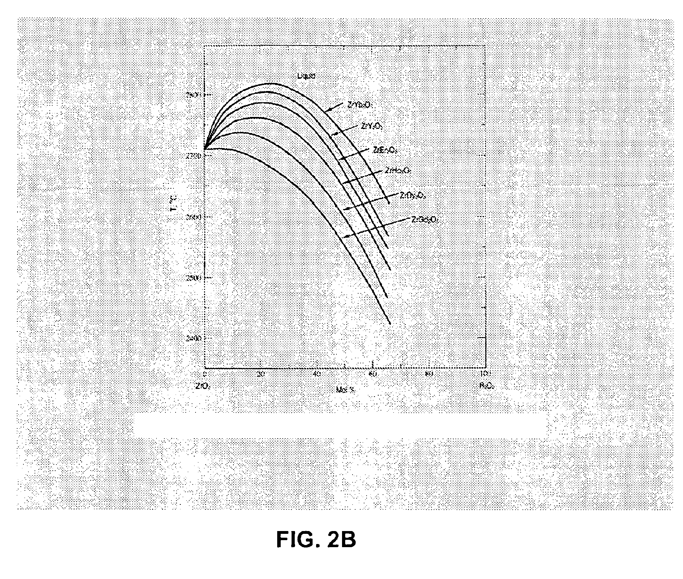

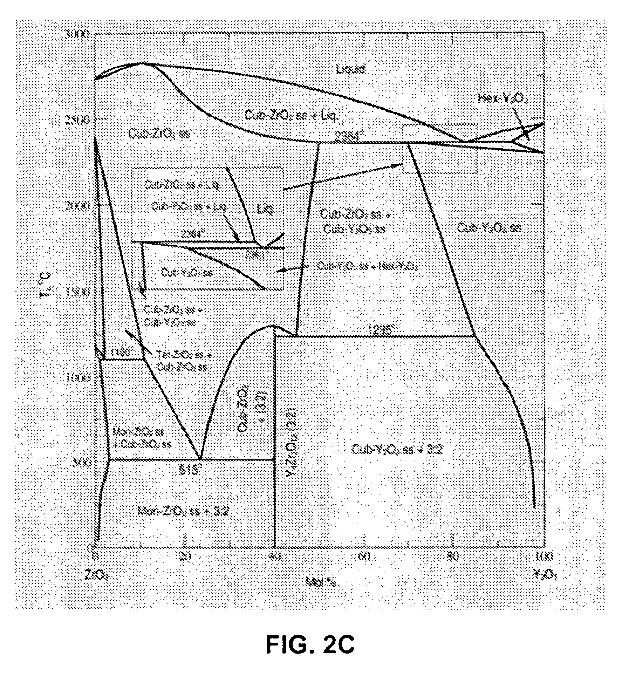

FIG. 2B provides a standard phase diagram for stabilized zirconia showing the general alloying trends for the zirconia stabilizers. A specific diagram for zirconia with yttria as a stabilizer is given in FIG. 2C. (The diagram can be found, for example, in Ceramic Phase Diagram, vol. Zirconia, figure Zr-157.) Zirconia can be either partially or fully stabilized. Fully stabilized zirconia has an crystal structure that is cubic at all temperatures up to melting. Partially stabilized zirconia has an crystal structure that is tetragonal and has a phase transformation between tetragonal at higher temperatures and monoclinic plus cubic at lower temperatures. The temperature at which phase transformation occurs depends on the stabilizer material, as each stabilizer causes a different amount of suppression of the temperature of the onset of the tetragonal to monoclinic plus cubic phase transformation. At the suppressed temperatures, the rate of the phase transformation is greatly reduced. Over a large number of temperature cycles the phase transformation will slowly occur.

One possible theory is that the phase transformation in partially stabilized zirconia causes localized stresses that lead to the formation of micron-sized micro-cracks in the coating upon thermal cycling that cancel out some of the massive stress caused by coating volume shrinkage. Thus, these two phenomena of the coating structure-shrinking and cracking- work against each other and finding a balance between them will maximize coating lifetime. This mechanism implies then that the structure of the crack network of the coating is changing with time as the phase of the ceramic material changes. This mechanism is required for a thermal barrier or high temperature abradable coatings to survive thermal cycling.

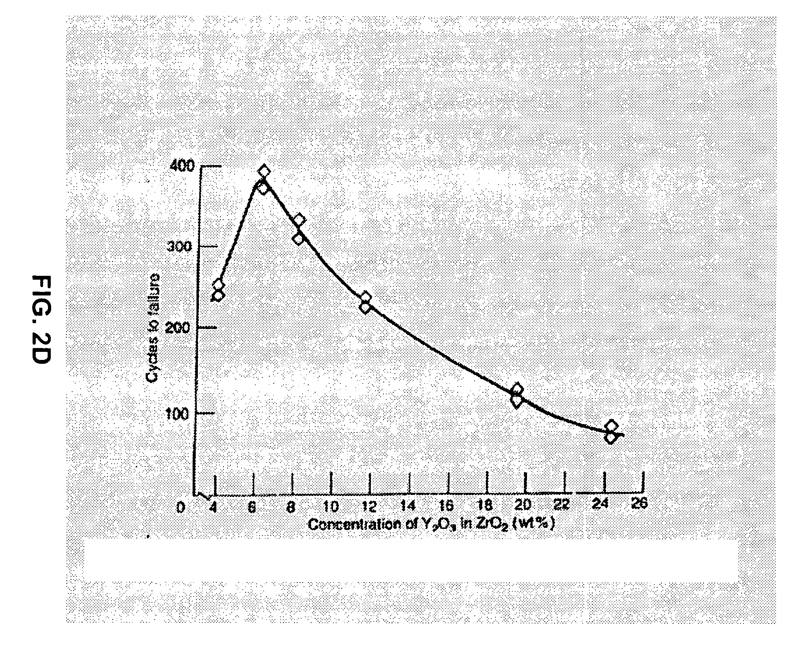

From this theory, the composition for which the best possible balance between sintering and phase transformation exists. The most desired composition can be found empirically by making thermal cycling tests with samples of differing composition and measuring the number of thermal cycles to failure. FIG. 2D shows the results for yttria-stabilized zirconia. From FIG. 2D it can be seen that a composition around 6.5 weight percent has the longest lifetime when similar coatings of varying composition were tested.

The addition of a stabilizing element affects two main properties of the zirconia coating system in a positive manner. First, the addition of a stabilizer as illustrated in FIG. 2B generally increases the melting temperature of the zirconia (in the partially stabilized composition ranges). Second, the addition of a stabilizer generally decreases the thermal conductivity. Once the critical composition that has the highest thermal cycling values is found experimentally for a stabilizer, the stabilizers can be compared by the melting point at the critical composition.

While yttria stabilized zirconia is the material of choice for stabilization, greater operational temperatures can be achieved using ytterbia (FIG. 2B) for example. Zirconia partially stabilized by ytterbia provides a better composition, since it also has one of the lowest thermal conductivities of the potential stabilizers when alloyed with zirconia. As the need for higher operating temperatures increases, a higher coating material cost may be tolerated, so ytterbia partially stabilized zirconia may become a preferred thermal barrier or high temperature abradable coating system. Given then the trade-offs of cost and performance, a combination of both yttria and ytterbia stabilizers is expected to have optimum performance to cost ratio.

The high purity zirconia or hafnia based material of present invention is a partially stabilized zirconia or hafnia solid solution. The stabilizer can be one or any combination of the following oxides: yttria (Y₂O₃), ytterbia (Yb₂O₅), scandia (Sc₂O₃), lanthanide oxide and actinide oxide. For purposes of the invention, these oxides (namely, any oxide from group IIIB (column 3) of the periodic table of elements) can be referred to as rare earth oxides. The concentration range of stabilizers may vary generally between about 4-20 weight percent, depending upon the ratio of zirconia and hafnia in the material. The concentration ranges of some stabilizers are about as follows:
Y₂O₃ - 4-12 weight percent
Yb₂O₅ - 4-16 weight percent
Y₂O₃ and Yb₂O₅ - 4-16 weight percent
Y₂O₃ and Yb₂O₅ and Sc₂O₃ or lanthanide oxide - 4-16 weight percent
In a preferred embodiment, the concentration ranges are about:
Y₂O₃ - 6-9 weight percent
Yb₂O₅ - 10-16 weight percent
Y₂O₃ and Yb₂O₅ - 4-16 weight percent
Y₂O₃ and Yb₂O₅ and Sc₂O₃ or lanthanide oxide - 4-16 weight percent.

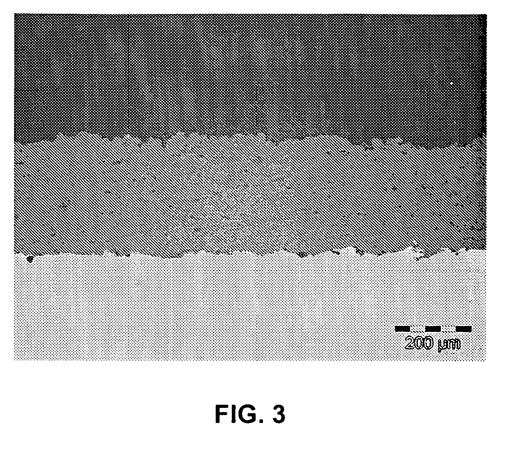

The material of present invention provides a significantly improved sintering resistance to thermal barrier coatings for high temperature cycling applications. As an example, high purity 7YSZ material was compared with currently used 7YSZ powders of lower purity. When materials containing various amounts of impurity oxides (see Table 1) were plasma sprayed to form coating of similar microstructure (see FIG. 3), it was found that the coating made from the invention material exhibits significantly improved sintering resistance. FIG. 4 shows the results of the dilatometry measurements on these coatings at 1400°C. Shrinkage of coating is a result of sintering. More shrinkage indicates a higher degree of sintering. As shown in FIG. 4, the shrinkage of the high purity coating (AE9171: 0.12% shrinkage) was reduced by more than 80 percent relative to that of low purity coatings (AE9212: 0.73% shrinkage and AE9213: 0.65% shrinkage).

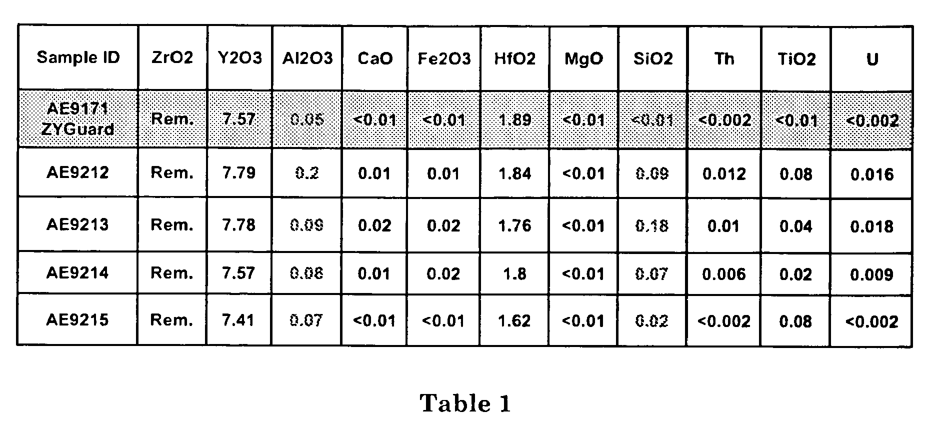

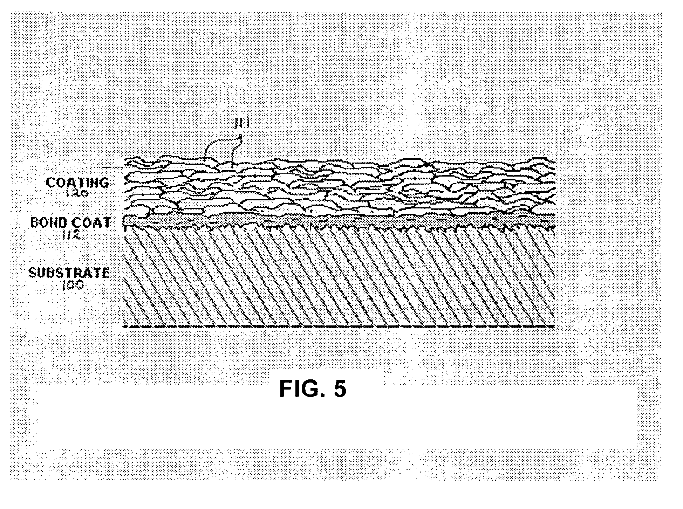

As mentioned earlier, porosities and cracks provide strain tolerance to TBCs and help to reduce thermal conductivities. Using thermal spray process, such as air plasma spray, flame spray or low pressure plasma spray, a high purity coating structure 120 (shown in FIG. 5) that comprise a ceramic matrix, porosity and microcracks can be achieved. The high purity coating structure is formed by injecting particles of invention high purity materials into a high temperature and high velocity flame. These particles are then heated and accelerated in the flame. Before reaching the substrate, some particles are molten, while some other particles are semi-molten or not melted. Referring to FIG. 5, molten and semi-molten particles strike on the substrate 100 (or optional bond coat 112) and then spread and solidify rapidly to form disk-like deposits 111, which are referred to as splats. Although some unmelted particles are entrapped and incorporated into the coating, most of them bounce off when they hit the substrate. The accumulation of splats and small amount of unmelted particles results in the coating formation. Due to shrinkage occurred during rapid solidification and imperfect packing of splats and unmelted particles, voids and cracks are generated in the coating. Herein, porosity refers to a void with an aspect ratio (length divided by width) of less than about 10. Typical porosity is in the range of about 5~20 volume percent, preferably in the range of about 7~15 volume percent. Micro cracks refers to a void with an aspect ratio (length divided by width) of larger than about 10 and the length of the void is less than about 100 micrometers. Typical volume percentage of micro cracks is in the range of about 2~15 volume percent, preferably in the range of about 5~10 volume percent.

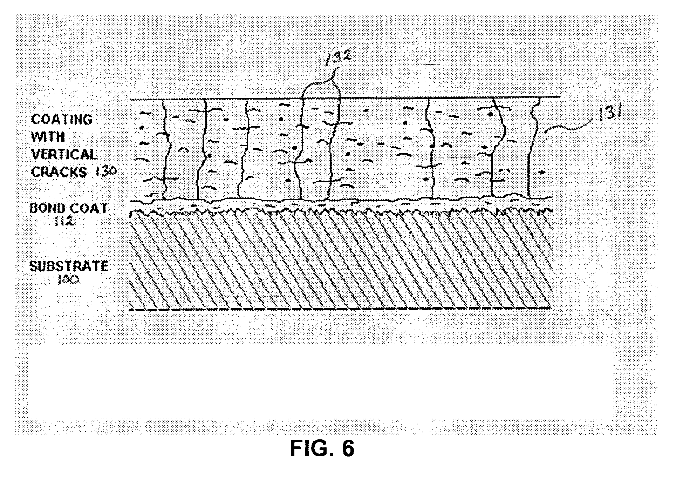

In order to enhance the strain tolerance of the aforementioned high purity TBCs, macro cracks that runs normal to the top coat and substrate interface can be introduced into the coating. As a result, another high purity coating structure that comprise a ceramic matrix, porosity, macro cracks and micro cracks (FIG. 6) can be achieved by thermal spray processes, such as air plasma spray, flame spray or low pressure plasma spray. The high purity coating structure 130 of FIG. 6 is formed by injecting particles of inventive materials into a high temperature and high velocity flame. These particles are then heated and accelerated in the flame. Before reaching the substrate, some particles are molten, while some other particles are semi-molten or not melted. Molten and semi-molten particles strike on the substrate 100 (or optional bond coat 112) and then spread and solidify rapidly to form disk-like deposits, which is referred to as splats. Although some unmelted particles are entrapped and incorporated into the coating, most of them bounce off when they hit the substrate. The accumulation of splats 131 and small amount of unmelted particles results in the coating formation 130. Due to shrinkage occurred during rapid solidification and imperfect packing of splats and unmelted particles, voids and cracks are generated in the coating. When coating deposition conditions are controlled to generate large shrinkage stress and improve the packing of splats to reduce voids and gaps between splats, cracks 132 normal to the coating 130 and substrate 100 interface are created. Herein, macro cracks refers to a void with an aspect ratio (length divided by width) of larger than about 10 and the length of the void is longer than about 100 micrometers. More than about 90% of the macro cracks are arranged in the direction normal to the top coat and substrate interface. These macro cracks are referred to as vertical macro cracks, while the macro cracks parallel to the top coat and substrate interface are referred to as horizontal vertical cracks. For this coating structure, typical volume percentage of porosity and micro cracks is less than about 10% and 5%, preferably less than about 5% and 3%, respectively. The average number of vertical macro cracks in a length of 25.4 mm along the top coat and substrate interface is in the range of about 5 to 250, preferably in the range of about 50 to 150.

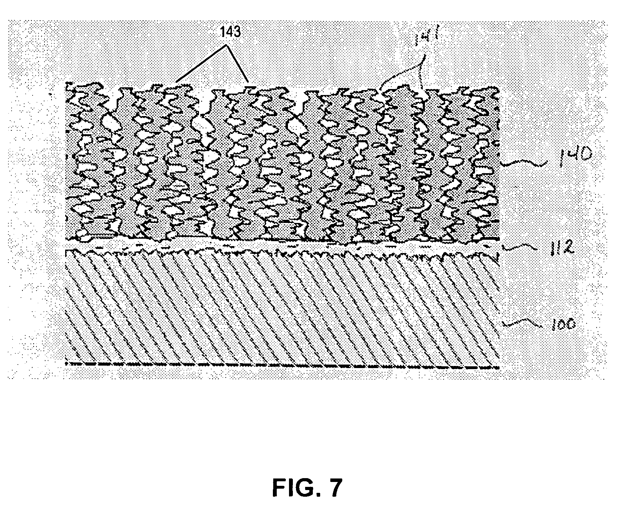

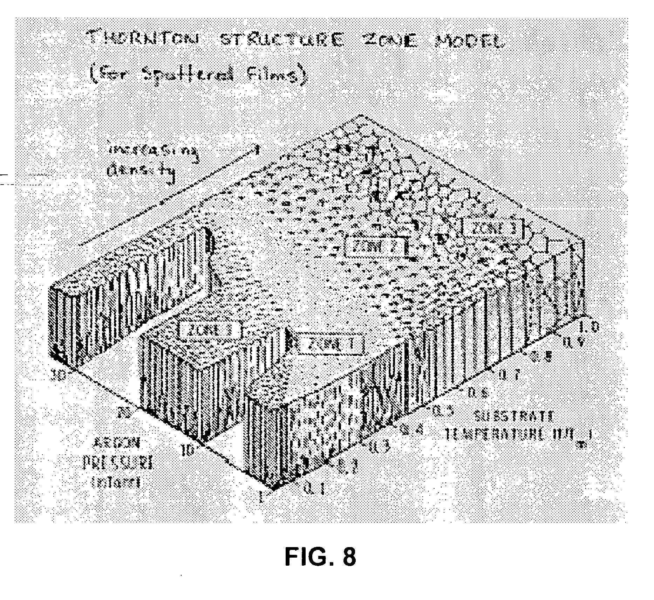

When coatings are produced using a vapor deposition process, such as electron beam assisted physical vapor deposition process (EB-PVD) or low pressure (lower than ambient) plasma spraying, the resulting coating has a unique columnar structure. The gaps between columns impart excellent strain tolerance to the coating. Accordingly, TBCs produce using vapor deposition process, such as EB-PVD or low pressure (lower than ambient) plasma spraying, usually have a higher durability than TBCs produced using thermal spray processes. As illustrated in FIG. 7, if vapor deposition process was employed, another high purity coating structure 140 that comprises ceramic columns 143 and gaps 141 between them can be achieved. An optional bond coat 112 is shown between the substrate 100 and the coating 140. The high purity coating structure 140 is formed by vaporizing the inventive high purity materials in a form of powder, ingot, target, solution or suspension. The formed vapor then deposited atomically on the substrate. By controlling processing temperature and pressure according to the Thornton's model (FIG. 8), a coating with columnar structure is formed. Herein, ceramic columns 143 are basically a cluster of crystals. More than about 90% of the crystals are at an angle of about 45 to 135 degree to the top coat and substrate interface. Within the cluster of crystals, voids smaller than about 20 micrometers are present. The gaps 141 between the columns have an aspect ratio (length divided by width) of larger than about 10. More than about 90% of the gaps are at an angle of about 45 to 135 degree to the top coat and substrate interface.

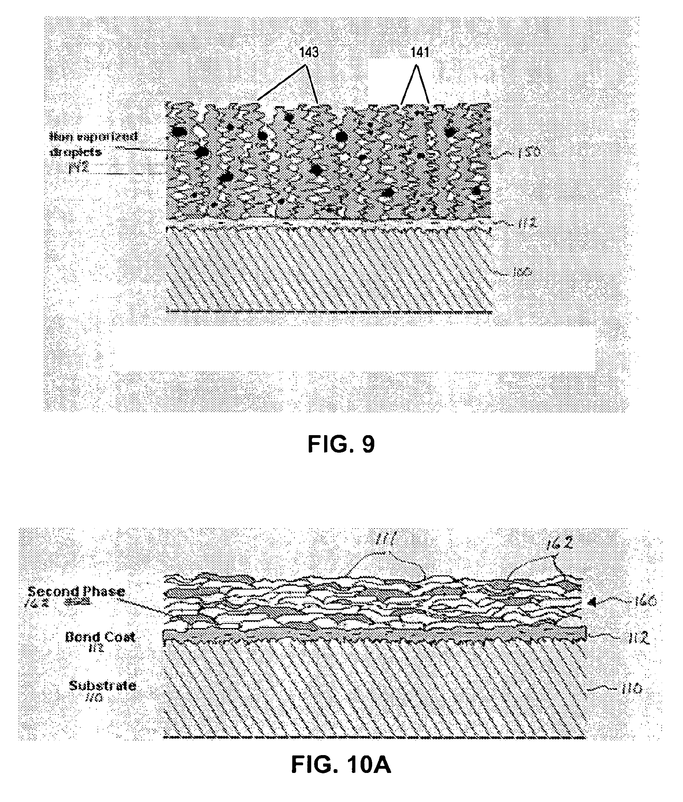

In low pressure (lower than ambient) plasma spraying process, if molten droplets are also generated during the vaporization of the invention high purity materials, then the entrapment and incorporation of these droplets into the coating results in the formation of another high purity coating structure. As illustrated in FIG. 9, the high purity coating structure 150 comprises ceramic columns 143, gaps between the columns 141, and nodules 142 distributing randomly in the gaps and columns. An optional bond coat 112 is shown between the substrate 100 and the coating 150. Herein, ceramic columns 143 are basically a cluster of crystals. More than 90% of the crystals are oriented at an angle of 45 to 135 degree to the top coat and substrate interface. Within the cluster of crystals 143, voids smaller than 20 micrometers are present. The gaps 141 between the columns have an aspect ratio (length divided by width) of larger than about 10. More than 90% of the gaps 141 are oriented at an angle of 45 to 135 degree to the top coat and substrate interface. The nodules 142 distributing randomly in the gaps and columns are frozen droplets. The size of these nodules 142 is typically less than about 45 micrometers, preferably less than about 30 micrometers.

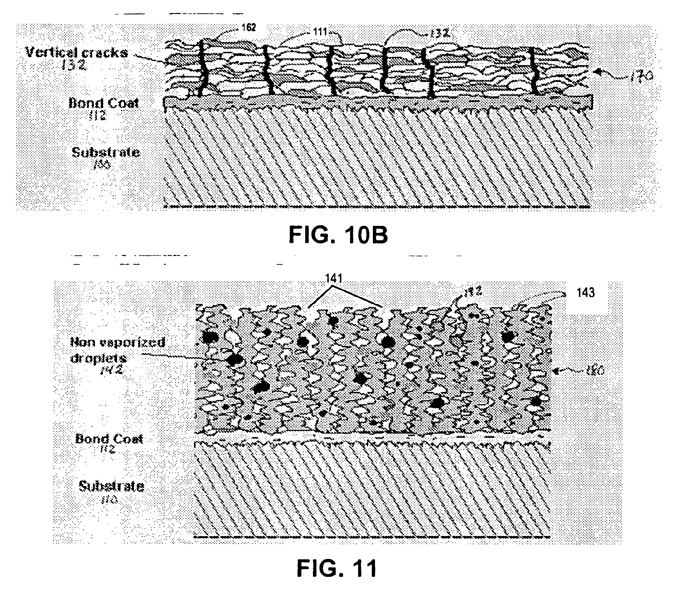

The ceramic coating in embodiments of the present invention has anisotropic sintering. For the coating made up of frozen splats with respect to FIGS. 6 and 7, high temperature shrinkage or sintering occurs less in the in-plane direction than in the through thickness direction. FIG. 6 provides a diagram showing a lamellar thermal barrier coating structure 120 containing porosity and micro cracks. The coating 120 is made up of frozen splats 111 applied over a substrate 100 and optional bond coat 112. FIG. 7 provides a diagram showing a lamellar thermal barrier coating structure 130 containing macro cracks, porosity and micro cracks. The coating 120 is made up of frozen splats 131 applied over a substrate 100 and optional bond coat 112. The coating 130 has vertical macro cracks 132 through the thickness of the coating For a coating made up of frozen splats, as shown in FIGs. 6 and 7, this phenomenon can be explained by the structure that is formed. The coating has many more splat boundaries in the through thickness direction than in the in-plane direction, so it is the boundaries between splats sintering together that results in the shrinkage in the through-thickness. Thus, the sintering resistance of the coating can be improved by using ytterbia partially stabilized zirconia and/or hafnia and yttria stabilized zirconia and/or hafnia together. FIG. 10A shows a resulting coating 160 structure (applied over optional bond coat 112 and substrate 110), where the frozen droplets of ytterbia partially stabilized zirconia and/or hafnia 111 are interspersed with splats of yttria stabilized zirconia and/or hafnia 162. FIG. 10B shows a resulting coating 170 structure (applied over optional bond coat 112 and substrate 110) including vertical cracks 132, where the frozen droplets of ytterbia partially stabilized zirconia and/or hafnia 111 are interspersed with splats of yttria stabilized zirconia and/or hafnia 162. One method of achieving this structure is by blending particles of each of the aforementioned in order to create some percentage splat boundaries that contain ytterbia stabilized zirconia on either one or both sides. An additional benefit of this coating will be that it has a lower thermal conductivity than a coating made from yttria stabilized zirconia and/or hafnia alone.

As previously noted, zirconia is transparent to radiation in the infrared range. Thus the effectiveness of typical zirconia barrier systems will decrease more rapidly at temperatures around 1500°C, when radiation becomes the dominant method of heat transfer. There are two stabilizers for zirconia from the lanthanide series that, when added to zirconia, form an atomic oxide structure that serves to scatter photons in the infrared range. These stabilizers are europia (Eu₂O₃) and neodymia (Nd₂O₃). Both neodymia and europia are effective stabilizers, but neodymia may be the more preferable due to its lower cost. The europia and neodymia can also be combined. In order to further optimize the thermal barrier coating at high temperatures, europia or neodymia are specifically added to the zirconia-based powder material, so that the thermal conductivity of the coating is optimized at high temperatures.

Thus, in embodiments of the invention the material includes zirconia (ZrO₂) and/or hafnia (HfO₂) wherein the zirconia and/or hafnia is partially stabilized by the neodymium (Nd₂O₃) and/or europia (Eu₂O₅) and the total amount of impurities is less than or equal to 0.15 weight percent, and preferably less than or equal to 0.10 percent. The range of stabilizers is:
Nd₂O₃ - 4-20 weight percent
Eu₂O₃ - 4-16 weight percent
Nd₂O₃ and Eu₂O₃ - 4-16 weight percent
and preferably:
Nd₂O₃ - 8-16 weight percent
Eu₂O₃ - 10-16 weight percent
Nd₂O₃ and Eu₂O₃ - 4-16 weight percent

Oxide impurities include soda (Na₂O), silica (SiO₂), and alumina (Al₂O₃), as well as titania (TiO₂)hematite (Fe₂O₃), calcia (CaO), and magnesia (MgO). The limits for these known oxide impurities in order to achieve a desirable sintering rate and therefore increase service lifetime when used as a coating are the same as those listed above with respect to previous compositions.

A blend of two or more partially stabilized high-purity material compositions may also be used. For example, in another embodiment, a blended ceramic material for use in high-temperature thermal barriers is provided. The blended materials include a first material with a yttria (Y₂O₃) stabilizer, and a balance of at least one of zirconia (ZrO₂) and hafnia (HfO₂) and combinations thereof, wherein the zirconia (ZrO₂) and/or hafnia (HfO₂) is partially stabilized by the yttria stabilizer, and wherein the total amount of impurities of the first material is less than or equal to 0.15 weight percent, and preferably less than or equal to 0.10 percent. The range of Y₂O₃ stabilizer is about 4-12 weight percent, and preferably 6-9 weight percent. The second material of the blended material may contain a ytterbia (Yb₂O₅) stabilizer and a balance of at least one of zirconia (ZrO₂) and hafnia (HfO₂) and combinations thereof, wherein the zirconia (ZrO₂) and/or hafnia (HfO₂) is partially stabilized by the ytterbia stabilizer, and wherein the total amount of impurities of the second material is less than or equal to 0.15 weight percent, and preferably less than or equal to 0.10 percent. The range of Yb₂O₅ stabilizer is about 4-16 weight percent, and preferably 10-16 weight percent. In the blended material, the ytterbia (Yb₂O₅) stabilized zirconia (ZrO₂) and/or hafnia (HfO₂) fraction may include about 5-50 weight percent of the total and preferably about 15-30 weight percent of the total. The yttria stabilized zirconia (ZrO₂) and/or hafnia (HfO₂) fraction may include about 50-95 weight percent of the total and preferably about 70-85 weight percent of the total blend.

In another embodiment the blended material includes a first material with a ytterbia (Yb₂O₅) stabilizer, and a balance of at least one of zirconia (ZrO₂) and hafnia (HfO₂) and combinations thereof, wherein the zirconia (ZrO₂) and/or hafnia (HfO₂) is partially stabilized by the ytterbia stabilizer, and wherein the total amount of impurities of the first material is less than or equal to 0.15 weight percent, and preferably less than or equal to 0.10 percent. The range of Yb₂O₅ stabilizer is about 4-16 weight percent, and preferably 10-16 weight percent. The second material of the blended material may contain a stabilizer of at least one of neodymium (Nd₂O₃), europia (Eu₂O₅), and combinations thereof and a balance of at least one of zirconia (ZrO₂) and hafnia (HfO₂) and combinations thereof, wherein the balance is partially stabilized by the stabilizer, and wherein the total amount of impurities of the second material is less than or equal to 0.15 weight percent, and preferably less than or equal to 0.10 percent. The range of Nd₂O₃ stabilizer is about 4-20 weight percent, and preferably 8-16 weight percent. The range of Eu₂O₃ stabilizer is about 4-16 weight percent, and preferably 10-16 weight percent. The range of the combined Nd₂O₃ and Eu₂O₃ stabilizer is about 4-16 weight percent. In the blended material, the ytterbia (Y₂O₃) stabilized zirconia (ZrO₂) and/or hafnia (HfO₂) fraction may include about 5-50 weight percent of the total and preferably about 15-30 weight percent of the total. The yttria stabilized zirconia (ZrO₂) and/or hafnia (HfO₂) fraction may include about 50-95 weight percent of the total and preferably about 70-85 weight percent of the total blend.

In another embodiment of the invention the blended material includes a first material with a yttria (Y₂O₃) stabilizer, and a balance of at least one of zirconia (ZrO₂) and hafnia (HfO₂) and combinations thereof, wherein the zirconia (ZrO₂) and/or hafnia (HfO₂) is partially stabilized by the yttria stabilizer, and wherein the total amount of impurities of the first material is less than or equal to 0.15 weight percent, and preferably less than or equal to 0.10 percent. The range of Y₂O₃ stabilizer is about 4-12 weight percent, and preferably 6-9 weight percent. The second material of the blended material may contain a stabilizer of at least one of neodymium (Nd₂O₃), europia (Eu₂O₅), and combinations thereof and a balance of at least one of zirconia (ZrO₂) and hafnia (HfO₂) and combinations thereof, wherein the balance is partially stabilized by the stabilizer, and wherein the total amount of impurities of the second material is less than or equal to 0.15 weight percent, and preferably less than or equal to 0.10 percent. The range of Nd₂O₃ stabilizer is about 4-20 weight percent, and preferably 8-16 weight percent. The range of Eu₂O₃ stabilizer is about 4-16 weight percent, and preferably 10-16 weight percent. The range of the combined Nd₂O₃ and Eu₂O₃ stabilizer is about 4-16 weight percent. In the blended material, the neodymium (Nd₂O₃) and/or europia (Eu₂O₅) stabilized zirconia (ZrO₂) and/or hafnia (HfO₂) fraction may include about 5-50 weight percent of the total and preferably about 15-30 weight percent of the total. The yttria stabilized zirconia (ZrO₂) and/or hafnia (HfO₂) fraction may include about 50-95 weight percent of the total and preferably about 70-85 weight percent of the total blend.

In a further embodiment of the invention the blended material includes a blend of at least three materials. The first material may contain a yttria (Y₂O₃) stabilizer, and a balance of at least one of zirconia (ZrO₂) and hafnia (HfO₂) and combinations thereof, wherein the zirconia (ZrO₂) and/or hafnia (HfO₂) is partially stabilized by the yttria stabilizer, and wherein the total amount of impurities of the first material is less than or equal to 0.15 weight percent, and preferably less than or equal to 0.10 percent. The range of Y₂O₃ stabilizer is about 4-12 weight percent, and preferably 6-9 weight percent. The second material of the blend may contain a ytterbia (Yb₂O₅) stabilizer, and a balance of at least one of zirconia (ZrO₂) and hafnia (HfO₂) and combinations thereof, wherein the zirconia (ZrO₂) and/or hafnia (HfO₂) is partially stabilized by the ytterbia stabilizer, and wherein the total amount of impurities of the second material is less than or equal to 0.15 weight percent, and preferably less than or equal to 0.10 percent. The range of Yb₂O₅ stabilizer is about 4-16 weight percent, and preferably 10-16 weight percent. The third material of the blend may contain a stabilizer of at least one of neodymium (Nd₂O₃), europia (Eu₂O₅), and combinations thereof and a balance of at least one of zirconia (ZrO₂) and hafnia (HfO₂) and combinations thereof, wherein the balance is partially stabilized by the stabilizer, and wherein the total amount of impurities of the third material is less than or equal to 0.15 weight percent, and preferably less than or equal to 0.10 percent. The range of Nd₂O₃ stabilizer is about 4-20 weight percent, and preferably 8-16 weight percent. The range of Eu₂O₃ stabilizer is about 4-16 weight percent, and preferably 10-16 weight percent. The range of the combined Nd₂O₃ and Eu₂O₃ stabilizer is about 4-16 weight percent. In the blended material, the ytterbia (Y₂O₃) stabilized zirconia (ZrO₂) and/or hafnia (HfO₂) fraction may include about 5-45 weight percent of the total, and preferably about 15-30 weight percent of the total. The neodymium (Nd₂O₃) and/or europia (Eu₂O₅) stabilized zirconia (ZrO₂) and/or hafnia (HfO₂) fraction may also include about 5-45 weight percent of the tota,1 and preferably about 15-30 weight percent of the total. The yttria stabilized zirconia (ZrO₂ and/or hafnia (HfO₂) fraction may include about 10-90 weight percent of the total, and preferably about 30-60 weight percent of the total blend.

The partially stabilized high-purity materials and blends described above may be supplied in the form of a powder, solution, suspension, ingot or target. Powder may be in the form of a spray dried powder of the individual constituents and organic binder, spray dried powder of the combined individual constituents and organic binder, fused and crushed powder, agglomerated and sintered powder, plasma densified material or powder from chemical solution routes. Typical particle sizes may vary but are typically between about 5 -150 microns when deposited by various thermal spray equipment, preferably between about 15 - 125 microns for air plasma spray. Particle sizes are typically less than about 45 microns, preferably less than about 30 microns, for low pressure plasma spray.

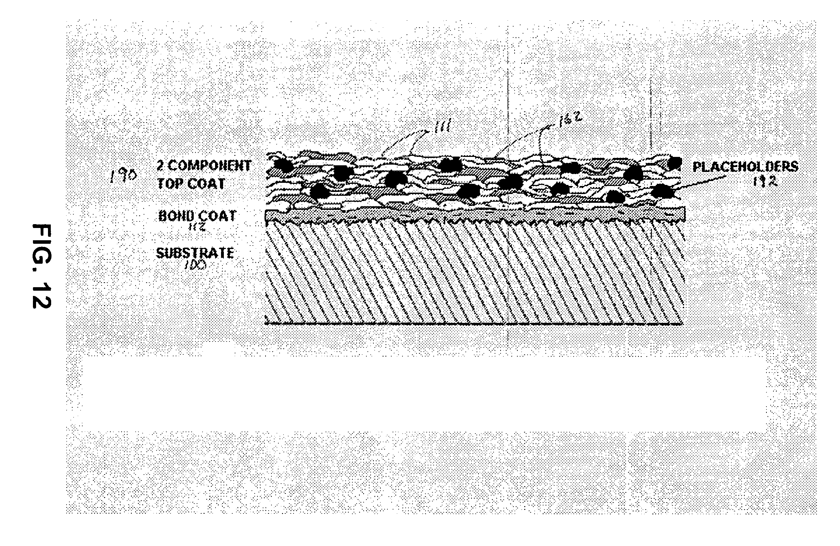

FIG. 12 provides a diagram showing a thermal barrier coating structure 190 formed from a blend of components 111, 162 and a placeholder 192. The placeholder material 192, made of an organic powder material or an inorganic powder material, can be burned out subsequent to deposition. The organic or inorganic powder material has particle sizes typically between about 5-150 microns, and preferably between about 15-125 microns for plasma spray. The placeholder material 192 may be combined with the material blends described above to provide an material for an applied coating structure with porosity. In certain embodiments, the blended material is about 70-90 volume percent of the total material blended with 10-30 volume percent of the placeholder material, and preferably 15-30 volume percent.

Using the materials and the material blends described above, a high purity coating structure suitable for high temperature cycling applications may be formed by DC or RF plasma or combustion spraying in air or inert atmospheres at pressures between 1 Pa and 1 MPa. Alternatively, the materials may be co-sprayed in the ratios of the materials described above. The porosity of the lamellar thermal barrier coating structure refers to a void with an aspect ratio (length divided by width) of less than about 10. Typical porosity is in the range of about 2~20 volume %, and preferably in the range of 7~15 volume %. The micro cracks refers to a void with an aspect ratio (length divided by width) of larger than about 10 and the length of the void is less than about 100 micrometers. Typical volume percentage of micro cracks is in the range of about 2~10 volume %, and preferably in the range of about 2~7 volume %.

The material and material blends discussed above may also be applied as a lamellar collection of frozen droplets and semi-molten droplets applied to a heated metal substrate to form a ceramic matrix, porosity, macro cracks and micro cracks. The porosity refers to a void with an aspect ratio (length divided by width) of less than about 10. Typical porosity for this structure is less than about 12 volume %, and preferably less than about 5 volume %. The macro cracks refer to a void with an aspect ratio (length divided by width) of larger than about 10 and the length of the void is longer than about 100 micrometers. More than about 90% of the macro cracks are arranged in the direction normal to the top coat and substrate interface. These macro cracks are referred to as vertical macro cracks, while the macro cracks parallel to the top coat and substrate interface are referred to as horizontal macro cracks. The average number of vertical macro cracks in a length of 25.4 mm along the top coat and substrate interface is in the range of about 5 to 250, preferably in the range of about 50 to 150. The structure may be subsequently heat-treated and cooled to form additional macro cracks perpendicular to the coating and substrate interface.

Using a different application process, the material and material blends discussed above may also be applied to form a high purity coating structure having ceramic columns and gaps between the columns. The materials may be applied using a vapor deposition process such as low pressure plasma spraying or physical vapor deposition in air or inert atmospheres at pressures between 1 mPa and 1 kPa. When coatings are produced using a vapor deposition process, the resulting coating has a unique columnar structure. The gaps between columns impart excellent strain tolerance to the coating. The high purity coating structure is formed by vaporizing the inventive high purity materials in a form of powder, ingot, target, solution or suspension. The formed vapor then deposited atomically on the substrate. By controlling processing temperature and pressure according to the Thornton's model (FIG. 8), a coating with columnar structure is formed. Herein, ceramic columns are basically a cluster of crystals. In low pressure (lower than ambient) plasma spraying process, if molten droplets are also generated during the vaporization of the invention high purity materials, then the entrapment and incorporation of these droplets into the coating results in the formation of another high purity coating structure. The ceramic columns are basically a cluster of crystals. In this structure, more than about 90% ofthe crystals are oriented at an angle of about 45 to 135 degrees to the top coat and substrate interface. Within the cluster of crystals, voids smaller than about 20 micrometers may be present. The gaps between the columns have an aspect ratio (length divided by width) of larger than about 10. More than about 90% of the gaps are oriented at an angle of about 45 to 135 degrees to the top coat and substrate interface. The frozen droplets distributing randomly in the gaps and columns are typically less than about 45 micrometers, and preferably less than 30 micrometers.

The material and material blends discussed above may also be applied to form a structure with ceramic columns, gaps between the columns and frozen droplets distributing randomly in the gaps and columns. The high purity coating structure comprises ceramic columns, gaps between the columns, and nodules distributing randomly in the gaps and columns. The nodules distributing randomly in the gaps and columns are frozen droplets. The size of these nodules is typically less than about 45 micrometers, preferably less than about 30 micrometers. FIG. 11 provides a diagram showing a columnar thermal barrier coating structure 180 formed from a blend of components. The coating structure of FIG. 11 includes the same components as shown in FIG. 9 (e.g., ref nos. 141, 142, and 143) and further includes a second coating material 182 interspersed throughout the ceramic columns 143. The ceramic columns are basically a cluster of crystals. In this structure, more than about 90% of the crystals are oriented at an angle of about 45 to 135 degrees to the top coat and substrate interface. Within the cluster of crystals, voids smaller than about 20 micrometers may be present. The gaps 141 between the columns have an aspect ratio (length divided by width) of larger than about 10. More than about 90% of the gaps are oriented at an angle of about 45 to 135 degrees to the top coat 180 and substrate 100 interface.

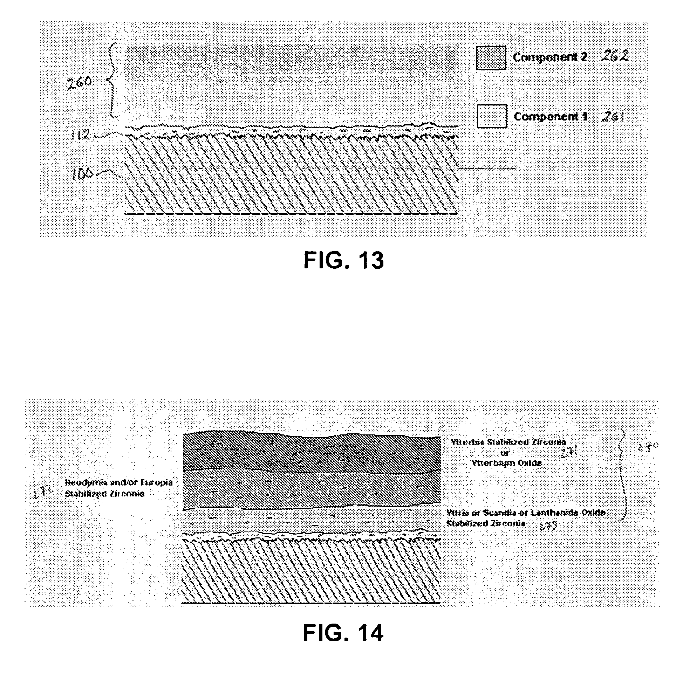

In accordance with the invention, a thermal barrier or high temperature abradable seal coating can be further optimized by building the coating in layers with different compositions, or by introducing a compositional gradient through the thickness of the coating. The reason for this is that due to the relatively low thermal conductivity of the coating, a temperature gradient exists in the coating during high temperature surface, since the substrate is being cooled. Thus there is a variation in the sintering rate through the thickness of the coating, and this means that the coating structure can be designed using the most optimal material at the surface, with less optimal materials towards the interface. Compositional gradients can be introduced into the coating during manufacture by using multiple feedstocks of different composition and varying their feed-rates during deposition. A coating with a compositional gradient is shown in FIG. 13, where the coating includes a starting material 261 most prominent along the surface of substrate 100 (or optional bond coat 112) and gradually giving way to starting material 262, which makes up most of the exterior surface of the coating 260. Materials 261 and 262 may be any of the materials described above with respect to embodiments of the present invention. Coating structures for the compositional gradients may include any of the structures described above.

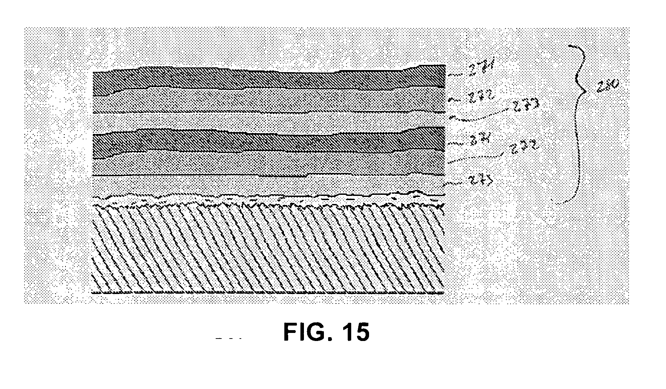

In addition to optimizing the coating by using compositional gradients, the coating can also be optimized by manufacturing it in layers with different compositions. The coating can have two or more layers, or multiple repeating layers. For example of one embodiment, as shown in FIG. 14, a coating 270 with a top layer 271 made from a material with optimized sintering resistance (for example, ytterbia stabilized zirconia according to embodiments of the present invention), a middle layer 272 with photon scattering capabilities (for example, neodymia and/or europia stabilized zirconia according to embodiments of the present invention) and a bottom layer 273 made from a third composition (for example, zirconia stabilized with yttria or scandia or a lanthanide oxide according to embodiments of the present invention). Another example is FIG. 15, showing a coating 280 with a repeating pattern of layers including a top layer 271, middle layer 272, and bottom layer 273 repeated, as shown. The combinations in FIGS. 14 and 15 serve only as examples. One skilled in the art will recognize numerous material combinations and coating structures as described herein may be layered to achieve optimal coating performance for various service conditions.

Embodiments of the present invention are used to increase the operation life and temperature of ceramic seal systems using high purity zirconia based ceramics. Modern large gas turbine engines employ axial compressors and turbines. An axial flow stage comprises a plurality of airfoils mounted radially at the periphery of a disk that is secured to a shaft. In the compressor section the airfoils act on the air to compress it whereas in the turbine section the products of combustion act on the turbine blade to cause rotation. Axial flow stages are surrounded by a case structure which serves in part to eliminate the leakage of flow around the free ends of the blades. Such leakage is wasteful and reduces efficiency. Modem gas turbine engine designers have gone to great lengths to devise useful sealing structures that generally comprise an abradable coating on the case surface, usually in combination with a blade tip treatment which renders the blade tips hard and resistant to wear. As shown, for example, in FIG. V, when in use, the blade tips cut a path into the abradable coating and provide sealing.

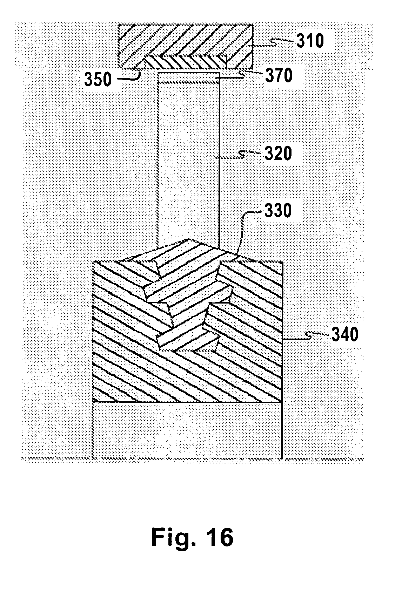

In embodiments of the present invention the casing surface of the blade is coated with a thermal barrier coating made of ultra-pure zirconia (ZrO₂) and/or hafnia (HfO₂). The ceramic abradable coating may be applied directly to the surface or on an MCrAlY bonding layer applied between the surface and the coating or applied to a graded or discrete layered cermet coating which is above the MCrAlY bond coat. FIG. 16 shows a cross-sectional view of a typical ceramic abradable coating system in a gas turbine engine. FIG. 16 shows a blade 320 that is affixed to a blade root 330 and disc 340. The disc 340 is driven so as to impart rotational movement to the blade 320. The blade 320 also has an abrasive tip 370 that may be made of an abrasive material, such as cubic boron nitride (cBN) embedded in a creep resistant alloy matrix. FIG. 16 also shows the casing segment 310 or shroud which acts to cover or house the entire gas turbine engine. An abradable seal coating 350 is provided between the abrasive tip 370 of the blade 320 and the casing segment 310. The coating 350 may be applied to the surface of the casing 310 through a variety of methods known in the art including thermal spray techniques such as powder flame spray, electro-photeric deposition (EPD), or preferably plasma spray. The material may be supplied as a powder, solution or suspension. Powder may be in the form of a spray dried powder of the individual constituents and organic binder, spray dried powder of the combined individual constituents and organic binder, fused and crushed powder, agglomerated and sintered powder, plasma densified material or powder from chemical solution routes. Typical particle sizes may vary, but are typically in the range of about 5-150 microns when deposited by various thermal spray equipments, preferably 15-125 microns for air plasma spray and about 30 microns or less for low pressure plasma spray.

When applied, the coating forms a crack network and voids (porosity) that allow it to survive the stress of numerous thermal cycles. Cracks are also formed and destroyed during service, mainly during thermal cycling; so the structure formed upon coating manufacture changes with time, depending on the starting material phases. Decreasing the sintering rate increases the amount of time before a critical fraction of cracks and pores are destroyed and eventual coating failure will occur.

Dysprosia (Dy₂O₃) may replace ytterbia as one of the stabilizing oxides. Thus, in accordance with embodiments of the invention, the stabilizer can be one or any combination of the following oxides: yttria (Y₂O₃), ytterbia (Yb₂O₅), scandia (Sc₂O₃), lanthanide oxide and actinide oxide. As with the previous-discussed stabilizer grouping, the concentration range of these stabilizers may vary depending upon the ratio of zirconia and hafnia in the material. Suitable concentration ranges of stabilizers are about:
Y₂O₃ - 4-12 weight percent,
Dy₂O₃ - 4-16 weight percent,
Y₂O₃ and Dy₂O₃ - 4-16 weight percent,
Y₂O₃ and Dy₂O₃ and Sc₂O₃ or lanthanide oxide - 4-16 weight percent; and preferably about:
Y₂O₃ - 6-9 weight percent,
Dy₂O₃ - 6-14 weight percent,
Y₂O₃ and Dy₂O₃ - 4-16 weight percent.

By adding porosity to the coating a decrease in sintering rate can be achieved. Porosity can be introduced into the coating by adding to the material a different placeholder material (or fugitive phase) that can be removed later. If the coating is manufactured from a slurry, a foaming agent can be added in addition to agitation to introduce gas bubbles which become porosity upon drying of the coating.

Typically for thermal spray applications, a polymer or organic material in powder form can be added to the material blend. Powder may be in the form of a spray dried powder of the individual constituents and an organic binder, spray dried powder of the combined individual constituents and an organic binder, fused and crushed powder, agglomerated and sintered powder, plasma densified material or powder from chemical solution routes. The organic binder may be used to at least partially bond together the placeholder material and the ceramic material. For high temperature abradable coatings, the benefit of adding a fugitive phase is that a higher porosity than is achievable with conventional deposition methods. The increased porosity aids abradability by introducing more surfaces to the crack network of the coating, decreasing the coating elastic modulus and thus promoting controlled material removal. Thus, according to an embodiment of the invention, a coating material may have about 70 to 99 weight percent of a partially stabilized ultra-pure ceramic material as previously described and about 1-30 weight percent (and preferably 2-15 weight percent) of a placeholder material. The placeholder material may be an organic powder material or an inorganic powder material that can be burned out subsequent to deposition of the coating material.

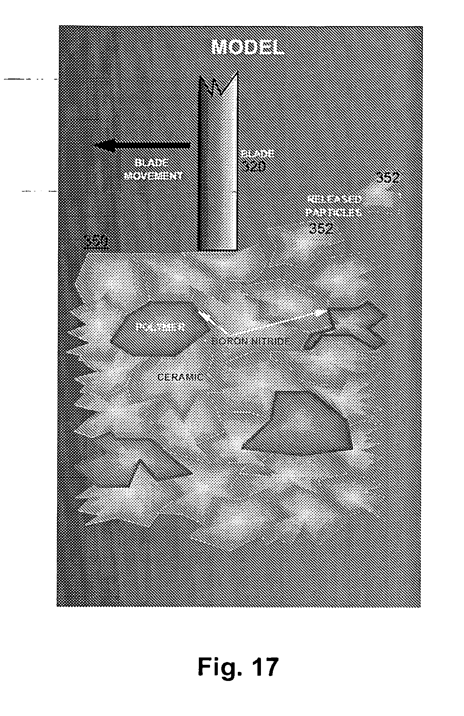

In some typical thermal spray applications embodiments of the coating structure of the present invention may be formed by blending, agglomerating or cladding together the ceramic material and the placeholder material prior to said spraying. Other thermal spray applications may apply the ceramic material and the placeholder material in a co-spraying process. FIG. 17 is a typical model on how ceramic interacts and performs as an abradable when subjected to a superalloy blade. As the blade 320 rotates, the blade 320 (which may have an abrasive tip, not shown) may contact an abradable seal coating 350 made from ceramic material is accordance with the present invention. The coating 350 is provided between the tip of the blade 320 and a casing segment (not shown). As the blade 320 contacts the coating 350, individual coating particles 352 may be broken off.

In accordance with embodiments of the invention, a high temperature abradable seal coating can be further optimized by building the coating in layers with different compositions, or by introducing a compositional gradient through the thickness of the coating. The reason for this is that due to the relatively low thermal conductivity of the coating, a temperature gradient exists in the coating during high temperature service. Thus there is a variation in the sintering rate through the thickness of the coating, and this means that the coating structure can be designed using the most optimal material at the surface, with less optimal materials towards the interface. Compositional gradients can be introduced into the coating during manufacture by using multiple feedstocks of different composition and varying their feed-rates during deposition. A few examples of discrete or graded layers could be: 1) MCrAlY bond coat, high purity YSZ intermediate coating and porous YSZ top coat; 2) MCrAlY bond coat, high purity dense YSZ intermediate layer and porous high purity ytterbia stabilized zirconia and 3) MCrAlY bond coat, low K TBC type material using two or more multiple stabilizers from ytterbia, ceria, gadolinium oxide, yttria, dysprosia that are alloyed with high purity zirconia or hafnia and a thick porous ceramic seal (reduced sintering resistance) of high purity ytterbia stabilized zirconia.

A main property affecting the abradability of the coating is the elastic modulus. Since the elastic modulus increases with sintering, it is vital that a high temperature abradable coating has optimized sintering resistance. The thermal conductivity of the abradable coating does not need to be maximized because sometimes a higher thermal conductivity is required to remove frictional heating and avoid localized coating failure. A preferred coating structure for a high temperature abradable seal coating is lamellar with regular repeating porosity. For example, in some embodiments of the invention, properties of the high temperature abradable seal coating can be improved by spraying the ceramic material and the placeholder material onto a metal substrate using a thermal spray process at pressures between 1 Pa and 1 MPa, so as to form a stream of molten and/or semi-molten droplets that build up a coating of frozen lamellar splats subsequent to impact with the substrate. In a coating made from this application process, high temperature shrinkage or sintering occurs less in the in-plane direction of the droplets than in the through thickness direction. Typical porosity and micro cracks may be in the range of about 10 to 60 volume percent, preferably in the range of about 15 to 40 volume percent.

A high purity abradable seal top coat in accordance with embodiments of the present invention has improved sintering resistance compared to standard yttria stabilized zirconia based materials. Typical coating thicknesses for the abradable coating materials described herein are about 0.5 mm to 5 mm. In embodiments of the invention, the coating material may be applied over 1) an oxidation and/or hot corrosion resistant MCrAlY or MAI or MCr bond coat; 2) an intermediate, about 0.2 to 1.0 mm thickness, zirconia-stabilized ceramic or hafnia-stabilized ceramic that has a main function of reducing heat transfer to the substrate and improving adhesion; or 3) an intermediate cermet of an oxidation resistant MCrAlY and a high purity zirconia/hafnia ceramic that has a function of reducing heat transfer and minimizing thermal expansion differences between the ceramic abradable top coat and MCrAlY bond coat or substrate. The abradable seal base material may be a superalloy grid surface based on investment casting or some other manufacture techniques.

While exemplary embodiments of the invention have been shown and described herein, it will be obvious to those skilled in the art that such embodiments are provided by way of example only. Numerous insubstantial variations, changes, and substitutions will now be apparent to those skilled in the art without departing from the scope of the invention disclosed herein by the Applicants. Accordingly, it is intended that the invention be limited only by the spirit and scope of the claims, as they will be allowed.

## Claims

1. A blended material for use in high-temperature thermal barrier coatings or abradable seal coatings comprising 70-99 weight percent of one or more ceramic materials and 1-30 weight percent of a organic or inorganic placeholder material, each ceramic material consisting of: 4 to 20 weight percent of a stabilizer of one or more rare earth oxides; and a balance of at least one of zirconia (ZrO₂), hafnia (HfO₂) and combinations thereof, wherein the zirconia (ZrO₂) and/or hafnia (HfO₂) is partially stabilized by the stabilizer, and wherein the total amount of impurities in the ceramic material is less than or equal to 0.15 weight percent.

2. The material of claim 1, wherein the stabilizer is 4-12 weight percent yttria.

3. The material of claim 1, wherein the stabilizer is 6-9 weight percent yttria.

4. The material of claim 1, wherein the stabilizer is 10-16 weight percent ytterbia.

5. The material of claim 1, wherein the stabilizer is 4-16 weight percent of a combination of yttria and ytterbia.

6. The material of claim 1, wherein the stabilizer is 4-16 weight percent dysprosia.

7. The material of claim 1, wherein the stabilizer is neodymia or europia or combinations thereof.

8. The material of claim 1, wherein the total stabilizer is 4-16 weight percent and includes a primary stabilizer of yttria and/or ytterbia and a secondary stabilizer of one or more other rare earth oxides.

9. The material of claim 1, wherein the total stabilizer is 4-16 weight percent and includes a primary stabilizer of dysprosia and a secondary stabilizer of one or more other rare earth oxides.

10. The material of claim 1, wherein the total stabilizer is 4-20 weight percent and includes a primary stabilizer of yttria and/or ytterbia and a secondary stabilizer of neodymia and/or europia and combinations thereof.

11. The material of claim 1, comprising a first ceramic material wherein the stabilizer is about 4-12 weight percent yttria; and a second ceramic material wherein the stabilizer is about 10-16 weight percent ytterbia.

12. The material of claim 1 comprising a first ceramic material and a second ceramic material, wherein the first ceramic material is 5 to 50 weight percent of the total ceramic material and the stabilizer of said first ceramic material is 4 to 12 weight percent yttria, and wherein the second ceramic material is 50 to 95 weight percent of the total ceramic material and the stabilizer of said second ceramic material is 4 to 16 weight percent ytterbia.

13. The material of any one of claims 1 to 12, wherein the ceramic material having oxide impurities of less than or equal to:
about 0.1 weight percent soda (Na₂O),
about 0.05 weight percent silica (SiO₂),
about 0.01 weight percent alumina (Al₂O₃),
about 0.05 weight percent titania (TiO₂),
about 0.05 weight percent hematite (Fe₂O₃),
about 0.05 weight percent calcia (CaO), and
about 0.05 weight percent magnesia (MgO).

14. The material of any one of claims 1 to 12, wherein the amount of oxide impurities in the ceramic material is less than or equal to:
about 0.1 weight percent soda (Na₂O),
about 0.01 weight percent silica (SiO₂),
about 0.01 weight percent alumina (Al₂O₃),
about 0.01 weight percent titania (TiO₂),
about 0.01 weight percent hematite (Fe₂O₃),
about 0.025 weight percent calcia (CaO), and
about 0.025 weight percent magnesia (MgO).

15. The material of any one of claims 1 to 12, wherein the ceramic material having oxide impurities of less than or equal to:
about 0.1 weight percent soda (Na₂O),
about 0.05 weight percent silica (SiO₂), and
about 0.01 weight percent alumina (Al₂O₃).

16. The material of one of claims 1 to 15, wherein the ceramic material is in the form of a powder or a slurry of partially stabilized powder.

17. The material of one of claims 1 to 16, wherein the placeholder material is a fugitive material.

18. The material of claim 17, wherein the placeholder material is a polymer, or carbon, or consists of hollow ceramic particles.

19. A high-purity coating applied to a substrate or bond coat, said coating having a ceramic matrix, a porosity in the range of 2-20 volume percent and micro-cracks, and the ceramic material consisting of:
4 to 20 weight percent of a stabilizer of one or more rare earth oxides; and a balance of at least one of zirconia (ZrO₂), hafnia (HfO₂) and combinations thereof, wherein the zirconia (ZrO₂) and/or hafnia (HfO₂) is partially stabilized by the stabilizer, and wherein the total amount of impurities in the ceramic material is less than or equal to 0.15 weight percent.

20. The coating of claim 19, wherein the porosity has an aspect ratio of less than 10.

21. The coating of claim 19 or 20, wherein said micro-cracks comprise a void having an aspect ratio of larger than 10 and a length of less than 100 micrometers.

22. The coating of any one of claims 19 to 21, wherein the coating further having macro-cracks.

23. The coating of claim 22, wherein the porosity is less than 12 volume percent.

24. A method for producing a high-purity coating structure suitable for high temperature cycling applications, said method comprising:
providing in a form suitable for use in thermal spraying applications a material comprising one or more ceramic material, each ceramic material consisting of 4 to 20 weight percent of a stabilizer of one or more rare earth oxides, and a balance of at least one of zirconia (ZrO₂), hafnia (HfO₂) and combinations thereof, wherein the zirconia (ZrO₂) and/or hafnia (HfO₂) is partially stabilized by the stabilizer, and wherein the total amount of impurities is less than or equal to 0.15 weight percent; and
spraying said one or more materials onto a metal substrate or bond coat using a thermal spray process.

25. The method of claim 24, wherein said step of spraying is conducted at pressures between 1 Pa and 1 MPa, so as to form a stream of molten and/or semi-molten doplets that build up a coating of frozen lamellar splats subsequent to impact with the substrate.

26. The method of claim 24, wherein the step of spraying is conducted using a vapor deposition process at pressures between 1 mPa and 1 kPa, so as to form a coating with ceramic columns and gaps between the columns.

27. The method of claim 24, wherein the step of spraying is conducted using a low pressure plasma spray process at pressures between 1 Pa and 10 kPa, so as to form a coating having ceramic columns, gaps between the columns, and frozen droplets distributed randomly in the gaps and columns.

28. The method of any one of claims 24 to 27, further comprising the step of providing a placeholder material made of an inorganic powder material or an organic powder material that can be burned out subsequent to deposition of the blended material, said placeholder material comprising about 10-30 volume percent of the total materials.

29. The method of any one of claims 24 to 28, wherein at least two ceramic materials are provided and wherein the step of spraying the materials forms a compositional gradient through the thickness of the coating structure.

30. The method of any one of claims 24 to 29, wherein at least two ceramic materials are provided and wherein the step of spraying the materials forms at least one layers of each ceramic material through the thickness of the coating structure.

31. A high-purity abradable seal coating system comprising:
an abradable top coat comprising about 70-99 weight percent of a ceramic material and about 1-30 weight percent of a placeholder material, said a ceramic material consisting essentially of about 4 to 20 weight percent of a stabilizer of one or more rare earth oxides, and a balance of at least one of zirconia (ZrO₂), hafnia (HfO₂) and combinations thereof, wherein the zirconia (ZrO₂) and/or hafnia (HfO₂) is partially stabilized by the stabilizer, and wherein the total amount of impurities is less than or equal to 0.15 weight percent, and said placeholder material comprising an organic powder material or an inorganic powder material that can be burned out subsequent to deposition of the coating material; and
one of an oxidation and/or hot corrosion resistant MCrAlY or MAl or MCr bond coat, an intermediate zirconia- or hafnia-stabilized ceramic, and an intermediate cermet of an oxidation-resistant MCrAlY and a high-purity zirconia/hafnia ceramic;
wherein the abradable top coat is applied over the bond coat, the zirconia- or hafnia-stabilized ceramic, or the intermediate cermet.

32. The coating system of claim 31, wherein the stabilizer is about 4-16 weight percent, said stabilizer having at least one of yttria (Y₂O₃), ytterbia (Yb₂O₅), and combinations thereof.

33. The coating system of claim 31, wherein the stabilizer is about 4-16 weight percent, said stabilizer having at least one of yttria (Y₂O₃), dysprosia (Dy₂O₃), and combinations thereof.

34. The coating system of any one of claims 31 to 33, wherein the abradable top coat has a thickness of about 0.5 mm to 5.0 mm.

35. The coating system of any one of claims 31 to 34, further comprising an abradable seal base material made from a superalloy grid surface.

36. The coating system of any one of claims 31 to 35, wherein the abradable top coat has a structure including a ceramic matrix, porosity, and micro cracks.

37. The coating system of claim 36, wherein the porosity and micro cracks are in the range of 10 to 60 volume percent.

38. The coating system of claim 36, wherein the porosity and micro cracks are in the range of about 15 to 40 volume percent.

## Patentansprüche

1. Mischmaterial zur Verwendung in thermischen Hochtemperatur-Sperrschichten oder in abreibbaren Dichtungsbeschichtungen enthaltend 70 bis 99 Gewichtsprozent eines oder mehrerer Keramikmaterialien und 1 bis 30 Gewichtsprozent eines organischen oder anorganischen Platzhaltermaterials, wobei jedes Keramikmaterial aus 4 bis 20 Gewichtsprozent eines Stabilisierungsmittels aus einem oder mehreren Seltenerdmetalloxiden und Rest wenigstens eines von Zirkoniumoxid (ZrO₂), Hafniumoxid (HfO₂) sowie Mischungen hiervon besteht, wobei das Zirkoniumoxid (ZrO₂) und/oder das Hafniumoxid (HfO₂) teilweise durch das Stabilisierungsmittel stabilisiert ist/ sind, und, wobei die Gesamtmenge der Verunreinigungen in dem Keramikmaterial weniger als oder gleich 0,15 Gewichtsprozent beträgt.

2. Material nach Anspruch 1, wobei das Stabilisierungsmittel 4 bis 12 Gewichtsprozent Yttriumoxid ausmacht.

3. Material nach Anspruch 1, wobei das Stabilisierungsmittel 6 bis 9 Gewichtsprozent Yttriumoxid ausmacht.

4. Material nach Anspruch 1, wobei das Stabilisierungsmittel 10 bis 16 Gewichtsprozent Ytterbiumoxid ausmacht.

5. Material nach Anspruch 1, wobei das Stabilisierungsmittel 4 bis 16 Gewichtsprozent einer Mischung aus Yttriumoxid und Ytterbiumoxid ausmacht.

6. Material nach Anspruch 1, wobei das Stabilisierungsmittel 4 bis 16 Gewichtsprozent Dysprosiumoxid ausmacht.

7. Material nach Anspruch 1, wobei das Stabilisierungsmittel Neodymoxid oder Europiumoxid oder Mischungen hiervon ist.

8. Material nach Anspruch 1, wobei das Gesamtstabilisierungsmittel 4 bis 16 Gewichtsprozent ausmacht und ein primäres Stabilisierungsmittel aus Yttriumoxid und/oder Ytterbiumoxid sowie ein sekundäres Stabilisierungsmittel aus einem oder mehreren Seltenerdmetalloxiden enthält.

9. Material nach Anspruch 1, wobei das Gesamtstabilisierungsmittel 4 bis 16 Gewichtsprozent ausmacht und ein primäres Stabilisierungsmittel aus Dysprosiumoxid und ein sekundäres Stabilisierungsmittel aus einem oder mehreren Seltenerdmetalloxiden enthält.

10. Material nach Anspruch 1, wobei das Gesamtstabilisierungsmittel 4 bis 20 Gewichtsprozent ausmacht und ein primäres Stabilisierungsmittel aus Yttriumoxid und/oder Ytterbiumoxid sowie ein sekundäres Stabilisierungsmittel aus Neodymoxid und/oder Europiumoxid und Mischungen hiervon enthält.

11. Material nach Anspruch 1, welches ein erstes Keramikmaterial enthält, wobei das Stabilisierungsmittel 4 bis 12 Gewichtsprozent Yttriumoxid ist, sowie ein zweites Keramikmaterial enthält, wobei das Stabilisierungsmittel ungefähr 10 bis 16 Gewichtsprozent Ytterbiumoxid ist.

12. Material nach Anspruch 1, welches ein erstes Keramikmaterial und ein zweites Keramikmaterial enthält, wobei das erste Keramikmaterial 5 bis 50 Gewichtsprozent des gesamten Keramikmaterials ausmacht und das Stabilisierungsmittel des ersten Keramikmaterials 4 bis 12 Gewichtsprozent Yttriumoxid ist, und, wobei das zweite Keramikmaterial 50 bis 95 Gewichtsprozent des gesamten Keramikmaterials ausmacht und das Stabilisierungsmittel des zweiten Keramikmaterials 4 bis 16 Gewichtsprozent Ytterbiumoxid ist.

13. Material nach einem der Ansprüche 1 bis 12, wobei das Keramikmaterial Oxidverunreinigungen in einer Menge von weniger als oder kleiner als enthält:
ungefähr 0,1 Gewichtsprozent Soda (Na₂O),
ungefähr 0,05 Gewichtsprozent Siliziumdioxid (SiO₂),
ungefähr 0,01 Gewichtsprozent Aluminiumoxid (Al₂O₃),
ungefähr 0,05 Gewichtsprozent Titanoxid (TiO₂),
ungefähr 0,05 Gewichtsprozent Hämatit (Fe₂O₃),
ungefähr 0,05 Gewichtsprozent Calciumoxid (CaO) sowie
ungefähr 0,05 Gewichtsprozent Magnesiumoxid (MgO).

14. Material nach einem der Ansprüche 1 bis 12, wobei die Menge der Oxidverunreinigungen in dem Keramikmaterial weniger als oder gleich beträgt:
ungefähr 0,1 Gewichtsprozent Soda (Na₂O),
ungefähr 0,01 Gewichtsprozent Siliziumdioxid (SiO₂),
ungefähr 0,01 Gewichtsprozent Aluminiumoxid (Al₂O₃),
ungefähr 0,01 Gewichtsprozent Titanoxid (TiO₂),
ungefähr 0,01 Gewichtsprozent Hämatit (Fe₂O₃),
ungefähr 0,025 Gewichtsprozent Calciumoxid (CaO) sowie
ungefähr 0,025 Gewichtsprozent Magnesiumoxid (MgO).

15. Material nach einem der Ansprüche 1 bis 12, wobei das Keramikmaterial Oxidverunreinigungen in einer Menge von weniger als oder gleich enthält:
ungefähr 0,1 Gewichtsprozent Soda (Na₂O),
ungefähr 0,05 Gewichtsprozent Siliziumdioxid (SiO₂) sowie
ungefähr 0,01 Gewichtsprozent Aluminiumoxid (Al₂O₃).

16. Material nach einem der Ansprüche 1 bis 15, wobei das Keramikmaterial in der Form eines Pulvers oder einer Aufschlämmung von teilweise stabilisiertem Pulver vorliegt.

17. Material nach einem der Ansprüche 1 bis 16, wobei das Platzhaltermaterial ein flüchtiges Material ist.

18. Material nach Anspruch 17, wobei das Platzhaltermaterial ein Polymer oder Kohlenstoff ist oder aus hohlen Keramikpartikeln besteht.

19. Hochreine Beschichtung, welche auf ein Substrat oder auf eine Haftvermittlerschicht aufgebracht ist, wobei die Beschichtung eine Keramikmatrix enthält, eine Porosität in einem Bereich von 2 bis 20 Volumenprozent und Mikrorisse aufweist, und, wobei das Keramikmaterial besteht aus:
4 bis 20 Gewichtsprozent eines Stabilisierungsmittels aus einem oder mehreren Seltenerdmetalloxiden und Rest wenigstens eines von Zirkoniumoxid (ZrO₂), Hafniumoxid (HfO₂) sowie Mischungen hiervon, wobei das Zirkoniumoxid (ZrO₂) und/ oder das Hafniumoxid (HfO₂) teilweise durch das Stabilisierungsmittel stabilisiert wird, und, wobei die Gesamtmenge der Verunreinigungen in dem Keramikmaterial weniger als oder gleich 0,15 Gewichtsprozent beträgt.

20. Beschichtung nach Anspruch 19, wobei die Porosität ein Streckungsverhältnis von weniger als 10 aufweist.

21. Beschichtung nach Anspruch 19 oder 20, wobei die Mikrorisse einen Hohlraum mit einem Streckungsverhältnis von größer als 10 und mit einer Länge von weniger als 100 Mikrometern aufweisen.

22. Beschichtung nach einem der Ansprüche 19 bis 21, wobei die Beschichtung ferner Makrorisse aufweist.

23. Beschichtung nach Anspruch 22, wobei die Porosität weniger als 12 Volumenprozente beträgt.

24. Verfahren zum Herstellen einer hochreinen Beschichtungsstruktur, welche für zyklische Hochtemperaturanwendungen geeignet ist, wobei das Verfahren umfasst:
Bereitstellen in einer Form, welche zur Verwendung in thermischen Spritzverfahren geeignet ist, eines Materials, welches ein oder mehrere Keramikmaterialien enthält, wobei jedes Keramikmaterial aus 4 bis 20 Gewichtsprozent eines Stabilisierungsmittels aus einem oder mehreren Seltenerdmetalloxiden und Rest wenigstens eines von Zirkoniumoxid (ZrO₂), Hafniumoxid (HfO₂) und Mischungen hiervon besteht, wobei das Zirkoniumoxid (ZrO₂) und/oder das Hafniumoxid (HfO₂) teilweise durch das Stabilisierungsmittel stabilisiert ist, und, wobei die Gesamtmenge der Verunreinigungen weniger als oder gleich 0,15 Gewichtsprozent beträgt, und
Spritzen des einen Materials oder der mehreren Materialien auf ein Metallsubstrat oder auf eine Haftvermittlerschicht unter Verwendung eines thermischen Spritzverfahrens.

25. Verfahren nach Anspruch 24, wobei der Schritt des Spritzens bei einem Druck zwischen 1 Pa und 1 MPa durchgeführt wird, um einen Strom aus geschmolzenen und/oder halbgeschmolzenen Tröpfchen auszubilden, welche nach dem Einschlag in das Substrat eine Beschichtung aus gefrorenen lamellaren Tropfen ausbilden.

26. Verfahren nach Anspruch 24, wobei der Schritt des Spritzens unter Verwendung eines Dampfabscheideverfahrens bei Drücken zwischen 1 mPa und 1 kPa durchgeführt wird, um so eine Beschichtung mit Keramiksäulen und Spalten zwischen den Säulen auszubilden.

27. Verfahren nach Anspruch 24, wobei der Schritt des Spritzens unter Verwendung eines Niederdruckplasmaspritzverfahrens bei Drücken zwischen 1 Pa und 10 kPa durchgeführt wird, um so eine Beschichtung mit Keramiksäulen, Spalten zwischen den Säulen und gefrorenen Tröpfchen, welche zufällig in den Spalten und in den Säulen verteilt sind, auszubilden.

28. Verfahren nach einem der Ansprüche 24 bis 27, welches des Weiteren den Schritt des Bereitstellens des Platzhaltermaterials umfasst, welches aus einem anorganischen Pulvermaterial oder einem organischen Pulvermaterial hergestellt ist, welches nach der Abscheidung des Mischmaterials ausgebrannt werden kann, wobei das Platzhaltermaterial ungefähr 10 bis 30 Volumenprozent der Gesamtmaterialien ausmacht.

29. Verfahren nach einem der Ansprüche 24 bis 28, wobei wenigstens zwei Keramikmaterialien bereitgestellt werden, und, wobei der Schritt des Spritzens der Materialien einen Zusammensetzungsgradienten über die Dicke der Beschichtungsstruktur ausbildet.

30. Verfahren nach einem der Ansprüche 24 bis 29, wobei wenigstens zwei Keramikmaterialien bereitgestellt werden, und, wobei der Schritt des Spritzens der Materialien wenigstens eine Schicht jedes Keramikmaterials über die Dicke der Beschichtungsstruktur ausbildet.

31. Hochreines abreibbares Dichtungsbeschichtungssystem, welches enthält:
eine abreibbare Deckbeschichtung, welche ungefähr 70 bis 99 Gewichtsprozent eines Keramikmaterials und ungefähr 1 bis 30 Gewichtsprozent eines Platzhaltermaterials enthält, wobei das Keramikmaterial im Wesentlichen aus ungefähr 4 bis 20 Gewichtsprozent eines Stabilisierungsmittels aus einem oder mehreren Seltenerdmetalloxiden und Rest wenigstens eines von Zirkoniumoxid (ZrO₂), Hafniumoxid (HfO₂) sowie Mischungen hiervon besteht, wobei das Zirkoniumoxid (ZrO₂) und/oder das Hafniumoxid (HfO₂) teilweise durch das Stabilisierungsmittel stabilisiert ist, und, wobei die Gesamtmenge der Verunreinigungen weniger als oder gleich 0,15 Gewichtsprozent beträgt, und, wobei das Platzhaltermaterial ein organisches Pulvermaterial oder ein anorganisches Pulvermaterial enthält, welches nach der Abscheidung des Beschichtungsmaterials ausgebrannt werden kann, und
eine einer Oxidations- und/oder heißkorrosionsbeständigen MCrA-1Y- oder Mal- oder MCr-Haftvermittlerschicht, einer Zirkoniumoxid- oder Hafniumoxid-stabilisierten Zwischenkeramik und eines Zwischenzements aus einem oxidationsbeständigen MCrAlY und einer hochreinen Zirkoniumoxid/Hafniumoxid-Keramik,
wobei die abreibbare Deckbeschichtung über der Haftvermittlerschicht, der Zirkoniumoxid- oder Hafniumoxid-stabilisierten Keramik oder dem Zwischenzement aufgebracht ist.

32. Beschichtungssystem nach Anspruch 31, wobei das Stabilisierungsmittel ungefähr 4 bis 16 Gewichtsprozent ausmacht, wobei das Stabilisierungsmittel wenigstens eines von Yttriumoxid (Y₂O₃), Ytterbiumoxid (Yb₂O₅) und Mischungen hiervon enthält.

33. Beschichtungssystem nach Anspruch 31, wobei das Stabilisierungsmittel ungefähr 4 bis 16 Gewichtsprozent ausmacht, wobei das Stabilisierungsmittel wenigstens eines von Yttriumoxid (Y₂O₃), Dysprosiumoxid (Dy₂O₃) und Mischungen hiervon enthält.

34. Beschichtungssystem nach einem der Ansprüche 31 bis 33, wobei die abreibbare Deckbeschichtung eine Dicke von ungefähr 0,5 mm bis 5,0 mm aufweist.

35. Beschichtungssystem nach einem der Ansprüche 31 bis 34, welches ein abreibbares Dichtungsbasismaterial aus einer Superlegierung-Gitter-Oberfläche enthält.

36. Beschichtungssystem nach einem der Ansprüche 31 bis 35, wobei die abreibbare Deckbeschichtung eine Struktur aufweist, welche eine Keramikmatrix, Porosität und Mikrorisse enthält.

37. Beschichtungssystem nach Anspruch 36, wobei die Porosität und die Mikrorisse in einem Bereich zwischen 10 und 60 Volumenprozent betragen.

38. Beschichtungssystem nach Anspruch 36, wobei die Porosität und die Mikrorisse in einem Bereich zwischen 15 und 40 Volumenprozent betragen.

## Revendications

1. Matériau mélangé pour utilisation dans des revêtements formant barrière thermique de haute température ou revêtements d'étanchéité abradables comprenant 70-99 pour cent en poids d'un ou de plusieurs matériaux céramiques et 1-30 pour cent en poids d'un matériau de rembourrage organique ou inorganique, chaque matériau céramique consistant en: 4 à 20 pour cent en poids d'un stabilisateur d'un ou de plusieurs oxydes de terres rares; et un reste d'au moins un parmi zircone (ZrO₂), oxydes d'hafnium (HfO₂) et leurs combinaisons, où le zircone (ZrO₂) et/ou l'oxyde d'hafnium (HfO₂) est partiellement stabilisé par le stabilisateur, et où la quantité totale d'impuretés dans le matériau céramique est inférieure ou égale à 0,15 pour cent en poids.

2. Matériau selon la revendication 1, où le stabilisateur est 4 à 12 pour cent en poids d'oxyde d'yttrium.

3. Matériau selon la revendication 1, où le stabilisateur est 6-9 pour cent en poids d'oxyde d'yttrium.

4. Matériau selon la revendication 1, où le stabilisateur est 10-16 pour cent en poids oxyde d'ytterbium.

5. Matériau selon la revendication 1, où le stabilisateur est 4-16 pour cent en poids d'une combinaison d'oxyde d'yttrium et d'oxyde d'ytterbium.

6. Matériau selon la revendication 1, où le stabilisateur est 4-16 pour cent en poids d'oxyde de dysprosium.

7. Matériau selon la revendication 1, où le stabilisateur est l'oxyde de néodymium ou d'europium ou leurs combinaisons.

8. Matériau selon la revendication 1, où le stabilisateur total est 4-16 pour cent en poids et comprend un stabilisateur primaire d'oxyde d'ytrium et/ou d'oxyde d'yterbium et un stabilisateur secondaire d'un ou de plusieurs autres oxydes de terres rares.

9. Matériau selon la revendication 1, dans lequel le stabilisateur total est 4-16 pour cent en poids et comprend un stabilisateur primaire d'oxyde de dysprosium et un stabilisateur secondaire d'un ou de plusieurs autres oxydes de terres rares.

10. Matériau selon la revendication 1, où le stabilisateur total est 4-20 pour cent en poids et comprend un stabilisateur primaire d'oxyde d'yttrium et/ou d'oxyde d'ytterbium et un stabilisateur secondaire d'oxyde de néodymium et/ou d'europium et leurs combinaisons.

11. Matériau selon la revendication 1, comprenant un premier matériau céramique, où le stabilisateur est environ 4-12 pour cent en poids d'oxyde d'yttrium; et un deuxième matériau céramique où le stabilisateur est environ 10-16 pour cent en poids d'oxyde d'ytterbium.

12. Matériau selon la revendication 1, comprenant un premier matériau céramique et un deuxième matériau céramique, où le premier matériau céramique est 5 à 50 pour cent en poids du matériau céramique total, et le stabilisateur dudit premier matériau céramique est 4 à 12 pour cent en poids d'oxyde d'yttrium, et où le deuxième matériau céramique est 50 à 95 pour cent en poids du matériau céramique total, et le stabilisateur dudit deuxième matériau céramique est 4 à 16 pour cent en poids d'oxyde d'ytterbium.

13. Matériau selon l'une quelconque des revendications 1 à 12, où le matériau céramique ayant des impuretés d'oxyde inférieures ou égales à:
environ 0,1 pour cent en poids de soude (Na₂O),
environ 0,05 pour cent en poids de silice (SiO₂),
environ 0,01 pour cent en poids d'alumine (Al₂O₃),
environ 0,05 pour cent en poids de titane (TiO₂),
environ 0,05 pour cent en poids d'hématite (Fe₂O₃),
environ 0,05 pour cent en poids d'oxyde de calcium (CaO) et
environ 0,05 pour cent en poids d'oxyde de magnésium (MgO).

14. Matériau selon l'une quelconque des revendications 1 à 12, où la quantité d'impuretés d'oxyde dans le matériau céramique est inférieure ou égale à:
environ 0,1 pour cent en poids de soude (Na₂O),
environ 0,01 pour cent en poids de silice (SiO₂),
environ 0,01 pour cent en poids d'alumine (Al₂O₃),
environ 0,01 pour cent en poids de titane (TiO₂),
environ 0,01 pour cent en poids d'hématite (Fe₂O₃),
environ 0,025 pour cent en poids d'oxyde de calcium (CaO), et
environ 0,025 pour cent en poids d'oxyde de magnésium (MgO).

15. Matériau selon l'une quelconque des revendications 1 à 12, où le matériau céramique ayant des impuretés d'oxyde est inférieur ou égal à:
environ 0,1 pour cent en poids de soude (Na₂O),
environ 0,05 pour cent en poids de silice (SiO₂), et
environ 0,01 pour cent en poids d'alumine (Al₂O₃).

16. Matériau selon l'une quelconque des revendications 1 à 15, où le matériau céramique se présente sous la forme d'une poudre ou d'une boue de poudre partiellement stabilisée.

17. Matériau selon l'une quelconque des revendications 1 à 16, où le matériau de rembourrage est un matériau fugitif.

18. Matériau selon la revendication 17, où le matériau de rembourrage est un polymère ou un carbone et est constitué de particules céramiques creuses.

19. Revêtement de pureté élevée appliqué à un substrat ou revêtement de liaison, ledit revêtement comportant une matrice céramique, une porosité dans la plage de 2-20 pour cent volumique et des micro-craquelures, et le matériau céramique consistant en:
4 à 20 pour cent en poids d'un stabilisateur d'un ou de plusieurs oxydes de terres rares; et un reste d'au moins un parmi la zircone (ZrO₂), l'oxyde d'hafnium (HfO₂) et leurs combinaisons, où la zircone (ZrO₂) et/ou l'oxyde d'hafnium (HfO₂) est partiellement stabilisée par le stabilisateur, et où la quantité totale d'impuretés dans le matériau céramique est inférieure ou égale à 0,15 pour cent en poids.

20. Revêtement selon la revendication 19, où la porosité a un rapport d'aspect inférieur à 10.

21. Revêtement selon la revendication 19 ou 20, où lesdites microcraquelures comprennent un vide ayant un rapport d'aspect supérieur à 10 et une longueur inférieure à 100 micromètres.

22. Revêtement selon l'une quelconque des revendications 19 à 21, où le revêtement comprend en outre des macro-craquelures.

23. Revêtement selon la revendication 22, où la porosité est inférieure à 12 pour cent volumique.

24. Procédé pour produire une structure de revêtement de pureté élevée qui convient à des applications de cyclage à température élevée, ledit procédé comprenant: réaliser dans une forme apte à être utilisée dans des applications de pulvérisation thermique un matériau comprenant un ou plusieurs matériaux céramiques, chaque matériau céramique consistant en 4 à 20 pour cent en poids d'un stabilisateur d'un ou de plusieurs oxydes de terres rares, et un reste d'au moins un parmi la zircone (ZrO₂), oxyde d'hafnium (HfO₂) et leurs combinaisons, où la zircone (ZrO₂) et/ou l'oxyde d'hafnium (HfO₂) est partiellement stabilisé par le stabilisateur, et où la quantité totale d'impuretés est inférieure ou égale à 0,15 pour cent en poids; et
pulvériser un ou plusieurs matériaux précités sur un substrat métallique ou un revêtement de liaison en utilisant un processus de pulvérisation thermique.

25. Procédé selon la revendication 24, dans lequel ladite étape de pulvérisation est exécutée à des pressions entre 1 Pa et 1 MPa de manière à former un écoulement de gouttelettes fondues et/ou semi-fondues qui forment un revêtement d'éclat lamellaire congelé à la suite de l'impact avec le substrat.

26. Procédé selon la revendication 24, où l'étape de pulvérisation est exécutée en utilisant un processus de dépôt par évaporation sous vide à des pressions entre 1 mPa et 1 kPa, de manière à former un revêtement avec des colonnes céramiques et des espaces entre les colonnes.

27. Procédé selon la revendication 24, où l'étape de pulvérisation est exécutée en utilisant un processus de pulvérisation de plasma à basse pression à des pressions entre 1 Pa et 10 kPa, pour former un revêtement ayant des colonnes céramiques, des espaces entre les colonnes et des gouttelettes congelées distribuées aléatoirement dans les espaces et des gouttelettes congelées distribuées d'une manière aléatoire dans les espaces et les colonnes.

28. Procédé selon l'une quelconque des revendications 24 à 27, comprenant en outre l'étape consistant à réaliser un matériau de rembourrage constitué d'un matériau de poudre inorganique ou d'un matériau de poudre organique qui peut subir une combustion à la suite du dépôt du matériau mélangé, ledit matériau de rembourrage comprenant environ 10-30 pour cent en volume du total des matériaux.

29. Procédé selon l'une quelconque des revendications 24 à 28, dans lequel au moins deux matériaux céramiques sont réalisés, et où l'étape de pulvérisation des matériaux forme un gradient de composition à travers l'épaisseur de la structure de revêtement.

30. Procédé selon l'une quelconque des revendications 24 à 29, dans lequel au moins deux matériaux céramiques sont réalisés, et où l'étape de pulvérisation des matériaux forme au moins une couche de chaque matériau céramique à travers l'épaisseur de la structure de revêtement.

31. Système de revêtement d'étanchéité abradable de haute pureté, comprenant: un revêtement supérieur abradable comprenant environ 70-99 pour cent en poids d'un matériau céramique et environ 1-30 pour cent en poids d'un matériau de rembourrage, ledit matériau céramique étant constitué essentiellement d'environ 4 à 20 pour cent en poids d'un stabilisateur d'un ou de plusieurs oxydes de terres rares, et un reste d'au moins un parmi la zircone (ZrO₂), l'oxyde d'hafnium (HfO₂) et leurs combinaisons, et la zircone (ZrO₂) et/ou l'oxyde d'hafnium (HfO₂) est partiellement stabilisé par le stabilisateur, et où la quantité totale d'impuretés est inférieure ou égale à 0,15 pour cent en poids, et ledit matériau de rembourrage comprenant un matériau de poudre organique ou un matériau de poudre inorganique qui peut subir une combustion à la suite du dépôt du matériau de revêtement; et
un parmi un revêtement de liaison MCrAIY ou MAI ou MCr résistant à l'oxydation et/ou à la corrosion à chaud, une céramique intermédiaire stabilisée par le zircone ou l'oxyde d'hafnium et un cermet intermédiaire de MCrAIY résistant à l'oxydation et une céramique de zircone/oxyde d'hafnium de haute pureté;
où le revêtement supérieur abradable est appliqué au revêtement de liaison, à la céramique stabilisée par le zircone ou l'oxyde d'hafnium ou au cermet intermédiaire.

32. Système de revêtement selon la revendication 31, où le stabilisateur est environ 4-16 pour cent en poids, ledit stabilisateur ayant au moins un parmi l'oxyde d'yttrium (Y₂O₃), l'oxyde d'ytterbium (Yb₂O₅) et leurs combinaisons.

33. Système de revêtement selon la revendication 31, où le stabilisateur est environ 4-16 pour cent en poids, ledit stabilisateur ayant au moins un parmi l'oxyde d'yttrium (Y₂O₃), l'oxyde de dysprosium (Dy₂O₃) et leurs combinaisons.

34. Système de revêtement selon l'une quelconque des revendications 31 à 33, où le revêtement supérieur abradable a une épaisseur d'environ 0,5 mm à 5,0 mm.

35. Système de revêtement selon l'une quelconque des revendications 31 à 34, comprenant en outre un matériau de base étanche abradable réalisé à partir d'une surface de grille d'un superalliage.

36. Système de revêtement selon l'une quelconque des revendications 31 à 35, où le revêtement supérieur abradable a une structure incluant une matrice céramique, une porosité et des micro-craquelures.

37. Système de revêtement selon la revendication 36, où la porosité et les micro-craquelures sont dans la plage de 10 à 60 pour cent en volume.

38. Système de revêtement selon la revendication 36, où la porosité et les microcraquelures sont dans la plage d'environ 15 à 40 pour cent en volume.
